(19) Europäisches Patentamt
European Patent Office
Office européen des brevets

(11) **EP 2 381 467 A1**

(12) **EUROPEAN PATENT APPLICATION**
published in accordance with Art. 153(4) EPC

(43) Date of publication:
**26.10.2011 Bulletin 2011/43**

(51) Int Cl.:
*H01L 21/027* (2006.01)     *B29C 59/02* (2006.01)
*G11B 7/26* (2006.01)      *B29K 33/04* (2006.01)
*B29K 83/00* (2006.01)     *B29L 7/00* (2006.01)

(21) Application number: **10729240.1**

(22) Date of filing: **08.01.2010**

(86) International application number:
**PCT/JP2010/050134**

(87) International publication number:
**WO 2010/079820 (15.07.2010 Gazette 2010/28)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **08.01.2009 JP 2009002188**

(71) Applicant: **Bridgestone Corporation Tokyo 104-0031 (JP)**

(72) Inventors:
• **INAMIYA Takato**
  **Kodaira-Shi**
  **Tokyo 187-8531 (JP)**

• **HASHIMOTO Masashi**
  **Kodaira-Shi**
  **Tokyo 187-8531 (JP)**
• **KAIDA Eizou**
  **Kodaira-Shi**
  **Tokyo 187-8531 (JP)**

(74) Representative: **Lamb, Martin John Carstairs Marks & Clerk LLP 90 Long Acre London WC2E 9RA (GB)**

(54) **PHOTOCURABLE TRANSFER SHEET, AND METHOD FOR FORMING UNEVEN PATTERN USING SAME**

(57) The present invention is to provide a photo-curable transfer sheet suitable for the preparation of an intermediate stamper in a nanoimprint method, in which the peeling property from a mold having a fine concave-convex pattern used in the preparation of the intermediate stamper and the peeling property of a cured photo-curable resin that is a product having a fine concave-convex pattern transferred from the intermediate stamper are excellent, and the adhesion to a base film is good; and a method for forming a concave-convex pattern by using the above-mentioned photo-curable transfer sheet. The photo-curable transfer sheet 10 having a photo-curable transfer layer 11 comprising a photo-curable composition deformable by application of pressure, wherein the photo-curable composition comprises as a lubricant a silicone resin and/or a fluorine-atom-containing ethylenic compound, and a surface energy of the photo-curable transfer layer 11 is more than 20mN/m and less than 30mN/m; and a method for forming a concave-convex pattern by using the sheet.

FIG. 1

**Description**

Background of Invention

Field of the invention

The present invention relates to a photo-curable transfer sheet advantageously utilized in the preparation of electronic devices, optical elements or recording media, and a method for forming concave-convex pattern, particularly a nanoimprint method which belongs to a microfabrication technology.

Description of the Related Art

A microfabrication technology using a light or an electron beam, which is outstandingly developed, enables processing (fabrication) into dimension of approx. 100nm by using a light and processing into dimension of approx. 10nm by using an electron beam. However, microfabrication devices are expensive, and hence an inexpensive microfabrication technology is desired. To fit the purpose, nanoimprint technology is establishing a process for forming a desired circuit pattern on silicon substrate. The nanoimprint technology corresponds to the microfabrication technology enabling the formation of a more fine structure compared with a conventional press technology. The technology has no limit with respect to resolution, and the resolution depends on the accuracy of a prepared mold (metallic mold). Hence, if the mold can be finely prepared, an extremely fine structure can be easily formed by using a cheap device compared with a conventional photolithography.

The nanoimprint technology is largely divided into two types depending on materials to be transferred. One of the nanoimprint technologies is a thermal nanoimprint technology which is carried out by heating material to be transferred, subjecting it to plastic deformation by using a mold, and then cooling it to form pattern. The other of the nanoimprint technologies is a photo-nanoimprint technology which is carried out by applying a photo-curable liquid resin onto a substrate at room temperature, pressing a transparent mold to the liquid resin, and exposing the liquid resin on the substrate to light to cure it. Particularly, in the photo-nanoimprint technology, it is possible to form a pattern at room temperature, and therefore there is little strain caused by heating based on the difference between coefficient of thermal expansions of the substrate and the mold, whereby an accurate pattern can be formed. Hence, the photo-nanoimprint technology receives much attention as a technology instead of lithography for semiconductor or the like.

Though a pattern molding can be cheaply carried out by the nanoimprint technology, a resin is apt to stick to an original mold (metallic mold) as a mother stamper. If the resin sticks to the original mold, it is extremely difficult to repair the resin-sticking mold. The mold is highly expensive, and therefore the nanoimprint technology necessarily is not cheap from the viewpoint of the whole production cost.

Patent Document 1 (JP2007-165812 A) discloses an imprint method comprising two steps. In more detail, in a first step, a foil of plastic polymer such as thermoplastic polymer is placed on a template (the above mother stamper) having a surface on which a fine concave-convex pattern of micrometer or nanometer order size is formed, such that the surface of the foil is in contact with the surface of the template, and a pattern that the pattern of the template is inverted is formed on the surface of the polymer foil by imprint processing. And, in a second step, the pattern on the surface of the resultant polymer stamper (intermediate stamper) is processed by the same imprint processing as above to form a second inversed pattern (the same as the template) on another plastic polymer foil.

In this method, a product is obtained by molding (shape forming) using the intermediate stamper, and therefore the mother stamper (template) receives no serious damage. However, since a thermoplastic polymer is used for the preparation of the intermediate stamper, a large amount of energy and a long time period of one or more minute are required to heat and cool the polymer in the molding though a wide variety of polymers can be used. Thus it is difficult to reduce takt time (time period for processing) in the continuous production.

Further, Patent Document 1 also describes an example using a photo-curable resin together in the preparation of the intermediate stamper. However, the photo-curable resin is in the form of liquid, and therefore its use brings about poor workability and increases of cure shrinkage and unevenness of thickness, whereby the productivity such as reduction of takt time cannot be enhanced. Moreover, there are disadvantages that the peeling property from the mother stamper and the peeling property of the cured photo-curable resin are insufficient, the cured photo-curable resin corresponding to the product having a fine concave-convex pattern transferred from the intermediate stamper.

Patent Document 2 discloses a method for the improvement of the peeling property by adding an internal-curable silicone resin into an ultraviolet curable resin provided on a base film in the preparation of an intermediate stamper consisting of the ultraviolet curable resin.

Prior Patent Documents

Patent Documents

Patent Document 1: JP2007-165 812 A
Patent Document 2: JP09-63130 A

Brief Summary of the Invention

Problem to be solved by the invention

However, the ultraviolet curable resin used in Patent Document 2 is also in the form of liquid, and hence the method of Patent Document 2 does not resolve the disadvantages such as poor workability and increase of cure shrinkage. Further, in case of the addition of the silicone resin, a reduced additive amount does not show the improvement of the peeling property, while an increased additive amount does not ensure the adhesion to the base film. Thus the method of Patent Document 2 cannot be sufficiently satisfied.

The present inventors have revealed that the disadvantages such as poor workability and increase of cure shrinkage can be improved by using a sheet-shaped photo-curable resin (i.e., a photo-curable transfer sheet) instead of the liquid ultraviolet curable resin. However, only the addition of the silicon resin does not enable sufficient improvement of the peeling property.

Thus, an object of the present invention is to provide a photo-curable transfer sheet suitable for the preparation of an intermediate stamper in a nanoimprint method which is advantageously utilized in the preparation of electronic devices, optical parts and recording media, in which the peeling property from a mold having a fine concave-convex pattern used in the preparation of the intermediate stamper and the peeling property of a cured photo-curable resin corresponding to a product having a fine concave-convex pattern transferred from the intermediate stamper are excellent, and the adhesion to a base film is good.

Further, an object of the present invention is to provide a method for forming a concave-convex pattern by using the above-mentioned photo-curable transfer sheet.

Means for Solving Problem

The above-mentioned object can be attained by a photo-curable transfer sheet having a photo-curable transfer layer comprising a photo-curable composition deformable by application of pressure, wherein the photo-curable composition comprises as a lubricant a silicone resin and/or a fluorine-atom-containing ethylenic compound, and a surface energy of the photo-curable transfer layer is more than 20mN/m and less than 30mN/m. The use of the photo-curable transfer sheet brings about excellent peeling property from a mold, and excellent peeling property of a cured photo-curable resin that is a product having a fine concave-convex pattern transferred from an intermediate stamper in case of using the transfer sheet as the intermediate stamper, as well as good adhesion to the base film of the photo-curable transfer sheet.

Here, the surface energy is determined by measuring a contact angle using a contact angle instrument (Dropmaster, available from Kyowa Interface Science Co., Ltd., Standard solvent: water, 1-bromonaphthalene, diiodomethane) to obtain a value of the contact angle and analyzing the obtained value according to a geometrical average method based on an extended Fowkes equation of Kitazaki and Hata (Yasuaki Kitazaki, Toshio Hata et. al. , Journal of The Adhesion of Japan, Vol. 8(3), 1972, pages 131-141).

The preferred embodiments of the photo-curable transfer sheet according to the present invention are as follows:

(1) The silicone resin is a modified polysiloxane.
(2) The modified polysiloxane is a polysiloxane containing a (meth)acryloyl group.
(3) The fluorine-atom-containing ethylenic compound is one of fluoro (meth)acrylates.
(4) A transparent film comprising an adhesion layer and a polymer film is provided on one surface of the photo-curable transfer layer, and the adhesion layer is in contact with the photo-curable transfer layer.
(5) The polymer film is a polyester film.
(6) The adhesion layer comprises at least one selected from a polyester resin, a polyurethane resin and an acrylic resin.

Further, the above-mentioned object can be also attained by a method for forming a concave-convex pattern comprising of the steps (1) to (3):

a step (1) of placing a mold having a fine concave-convex pattern surface thereon on the photo-curable transfer layer of the photo-curable transfer sheet according to the present invention, such that the concave-convex pattern surface of the mold is in contact with a surface of the photo-curable transfer layer, and depressing the mold and the photo-curable transfer sheet to form a laminate in which one surface of the photo-curable transfer layer adheres closely to the concave-convex pattern surface;
a step (2) of exposing the photo-curable transfer layer of the laminate having the mold to ultraviolet rays to cure the photo-curable transfer layer, and
a step (3) of removing the mold from the laminate to form an inverted pattern of the fine concave-convex pattern on a surface of the photo-curable transfer layer.

In the method, the fine concave-convex pattern of the mold is transferred by using the photo-curable transfer sheet of the present invention. Therefore, the peeling property between the photo-curable transfer sheet and the mold is excellent, which brings about the formation of an inverted concave-convex pattern free of defect on the transfer layer without the adhesion of a part of the transfer layer to the mold. Thereby an expensive mold can be used without damage.
Furthermore, the above-mentioned object can be also attained by a method for forming a concave-convex pattern comprising of the steps (4) to (6):

a step (4) of placing the photo-curable transfer sheet having the inverted pattern surface of the fine concave-convex pattern obtained by the method as mentioned above, which is referred to as an intermediate stamper, on a photo-curable resin layer consisting of a photo-curable resin composition formed on a substrate, such that the inverted concave-convex pattern surface of the intermediate stamper is in contact with a surface of the photo-curable resin layer and depressing the intermediate stamper and the photo-curable resin layer having the substrate to form a laminate in which the surface of the photo-curable resin layer adheres closely to the inverted concave-convex pattern surface; and
a step (5) of exposing the photo-curable resin layer of the laminate having the intermediate stamper to ultraviolet rays to cure the photo-curable resin layer, and
a step (6) of removing the intermediate stamper from the laminate to form a fine concave-convex pattern on a surface of the photo-curable resin layer, the fine concave-convex pattern being the same as that of the mold.

In the method, the photo-curable transfer sheet of the present invention having the inverted pattern of the fine concave-convex pattern is used as an intermediate stamper, whereby the fine concave-convex pattern surface is transferred onto the photo-curable resin layer provided on the substrate. Therefore, the peeling property between the cured photo-curable resin layer and the intermediate stamper is excellent, which brings about the formation of a concave-convex pattern free of defect on the photo-curable resin layer without the adhesion of a part of the photo-curable resin layer to the intermediate stamper, the concave-convex pattern free of defect being the same as the mold.
The preferred embodiments of the method for forming a concave-convex pattern according to the present invention are as follows:

(1) The photo-curable resin composition is in the form of liquid. In the method of the present invention, even the liquid photo-curable resin composition shows excellent peeling property.
(2) The mold is a stamper. The method of the invention is effective for the formation of a fine concave-convex pattern by employing a stamper used in a nanoimprint method.

Effect of the invention

In the photo-curable transfer sheet of the present invention, a peeling property of the photo-curable transfer layer from a mold such as a stamper having a fine concave-convex pattern and a peeling property of the cured photo-curable resin that is the product having a fine concave-convex pattern transferred from the intermediate stamper are excellent, and the adhesion to a base film is also good. Therefore the pattern of the mold is precisely transferred to the transfer layer, and the mold is free from damage caused by adhesion of resin, and further the transfer sheet has excellent film self-supporting characteristics.
Thus, the method for forming a concave-convex pattern of the present invention (including a photo nanoimprint method) using the photo-curable transfer sheet of the invention enables an accurate transfer of the pattern of the mold and does not cause damage of an expensive stamper. Further, the photo-curable transfer sheet has excellent film self-supporting characteristics, and hence a handling property of the sheet is excellent, which brings about reduction of takt time in the continuous production to enhance the productivity and reduce the cost.

Thus, the use of the method for forming concave-convex pattern of the present invention advantageously enables the productions of electronic display ribs, electronic devices (lithography, transistor), optical elements (microlens array, waveguide, optical filter, photonic(s) crystal), bio-related materials (DNA tip, microreactor) and recording media (patterned media, DVD).

Brief Description of the Drawings

[Fig. 1]

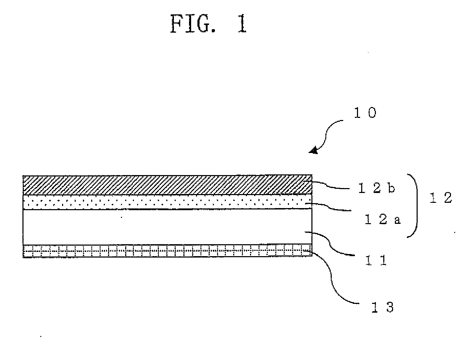

Fig. 1 is a schematic section view showing a representative example of the photo-curable transfer sheet of the present invention.
[Fig. 2]

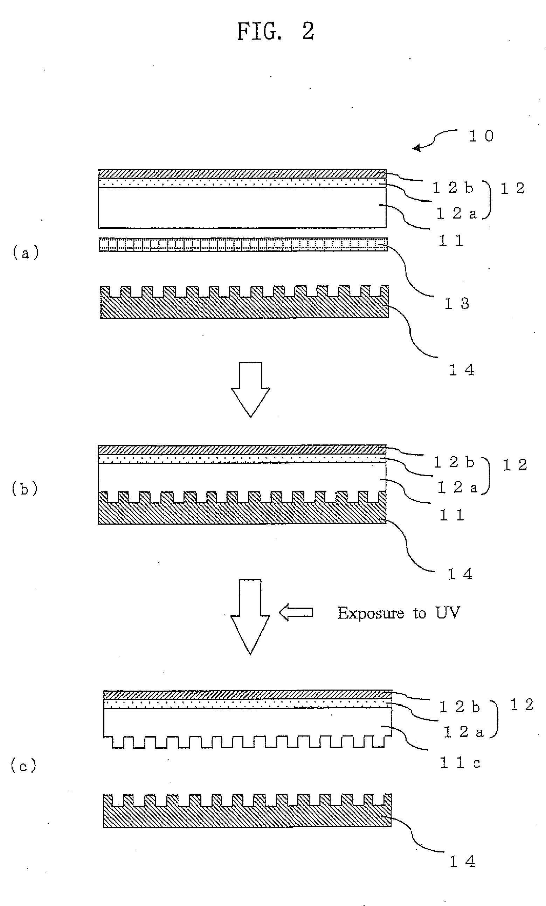

Fig. 2 is a schematic section view showing a representative example of a method for forming a fine concave-convex pattern of the present invention.
[Fig. 3]

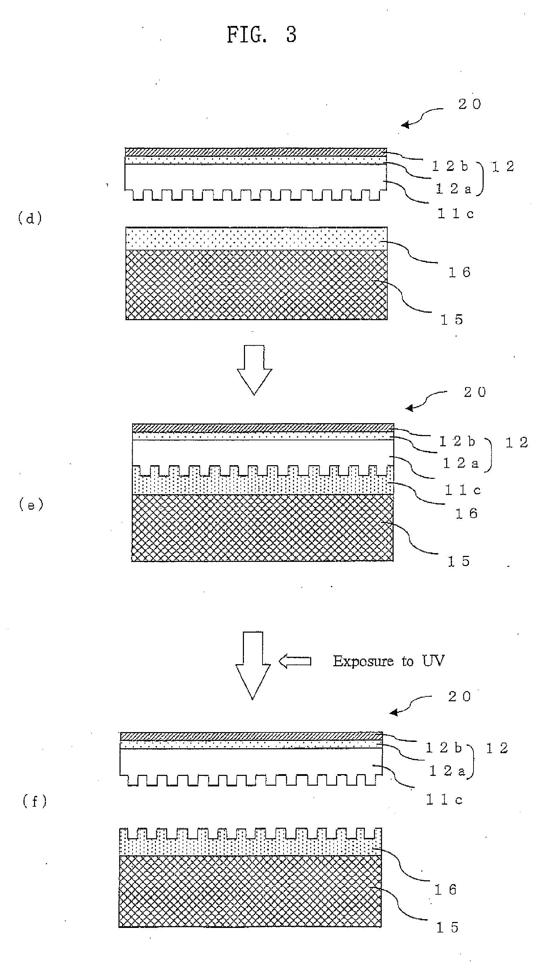

Fig. 3 is a schematic section view showing a representative example of a method for forming a fine concave-convex pattern of the present invention (in case of following after the stages of Fig. 2).
[Fig. 4]

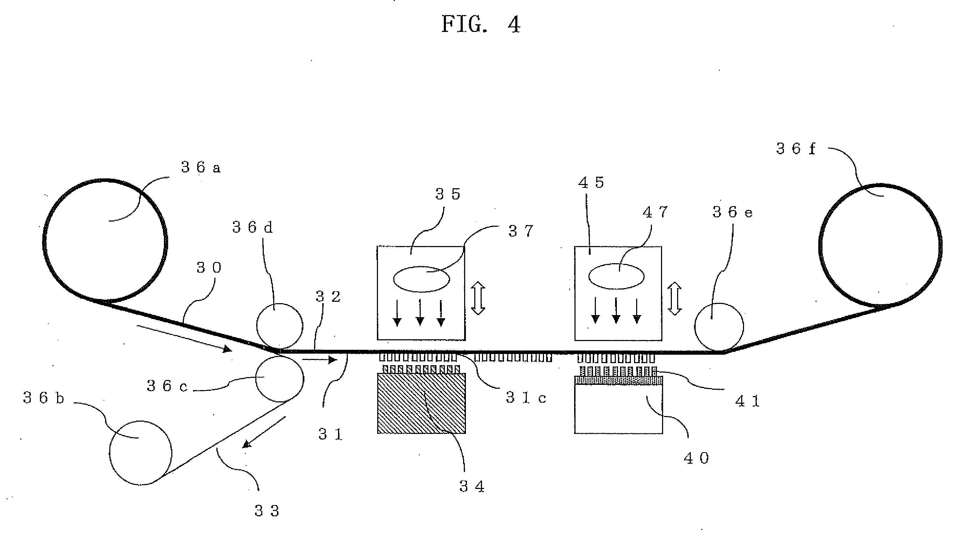

Fig. 4 is a schematic section view showing a representative example of a continuous method for forming a fme concave-convex pattern of the present invention.

Mode for Carrying out the Invention

Embodiments of the invention are explained in detail by referring to drawings.
Fig. 1 is a schematic section view showing a representative example of an embodiment of the photo-curable transfer sheet 10 of the present invention. A photo-curable transfer layer 11 has a transparent film 12 consisting of a polymer film 12b having an adhesion layer 12a on one side of the layer 11, and further has a release sheet 13 on the other side of the layer 11. The transparent film 12 strongly adheres to the photo-curable transfer layer 11 by the adhesion layer 12a. The adhesion layer 12a shows excellent adhesion properties to the photo-curable transfer layer 11, the cured photo-curable transfer layer 11 and the polymer film 12b. The polymer film 12b gives film self-supporting characteristics to the photo-curable transfer sheet 10 and the cured photo-curable transfer sheet 10. The release sheet 13 is provided for protection of the photo-curable transfer layer. Though the release sheet 13 therefore is not provided, it is preferred to provide it in view of handling in the case of using a continuous sheet. The release sheet 13 generally consists of a plastic sheet and a release layer provided thereon, and the release layer is in contact with a surface of the photo-curable transfer layer 11. The release sheet 13 is generally removed when the sheet is used.
The photo-curable transfer layer 11 is configured to be easily deformable by application of pressure such that a fine concave-convex pattern of a mold (preferably stamper) can be precisely transferred to the layer by depressing the mold and the layer, and at the same time, to have excellent peeling property (mold release characteristics) from the stamper after curing. Further, when the cured photo-curable transfer layer 11 is used as an intermediate stamper, it is excellent in peeling property from a cured photo-curable resin layer as a product having the transferred fine concave-convex pattern. Furthermore, the cured photo-curable transfer layer 11 shows excellent adhesion to the transparent film 12.
In more detail, the photo-curable transfer sheet 11 comprises a photo-curable composition (generally comprising a polymer and a reactive diluent having a photopolymerizable functional group), and further contains as a lubricant a silicone resin and/or a fluorine-atom-containing ethylenic compound, and a surface energy of the photo-curable transfer layer is more than 20mN/m and less than 30mN/m. Thereby, the cured photo-curable transfer layer 11 easily peels from the mold, and also from the cured photo-curable resin layer (a product having the transferred fine concave-convex pattern) in case of using it as an intermediate stamper, whereas the cured photo-curable transfer layer 11 shows improved adhesion to the transparent film 12.
When the surface energy of the photo-curable transfer layer is not more than 20mN/m, the cured photo-curable transfer layer shows insufficient adhesion to the transparent film and rejects the photo-curable resin layer as a product in case of using it as an intermediate stamper to bring about insufficient transfer of the fine concave-convex pattern. On the other hand, when the surface energy of the photo-curable transfer layer is not less than 30mN/m, the cured photo-curable transfer layer shows insufficient peeling properties from the mold and from the photo-curable resin layer as a product.
In the present invention, the photo-curable composition is generally composed mainly of a polymer, a reactive diluent (generally monomer or oligomer) having a photopolymerizable functional group (generally carbon-carbon double bond, preferably (meth)acryloyl group), a photopolymerization initiator, a silicone resin and/or a fluorine-atom-containing ethylenic compound as a lubricant, and if necessary other additives.

In the invention, the photo curable composition comprises a polymer having glass transition temperature of not less than 80°C, whereby the fine concave-convex pattern of the mold can be easily transferred and the curing can be carried out in high speed. Further the cured shape is maintained without variation of the shape for a long time period because of the high Tg. The polymer having glass transition temperature (Tg) of not less than 80°C preferably has a photopolymerizable functional group because it can be reacted with the reactive diluent to enhance the curing rate. The polymer preferably has hydroxyl group because the transfer layer can be a little cured by use of diisocyanate whereby exudation of the integrant of the layer and variation of the thickness are greatly suppressed. The use of the diisocyanate is effective to some extent even if the polymer has no hydroxy group.

As the silicone resin as a lubricant to be added to the photo-curable composition, any silicone resin can be used as long as it is capable of adjusting the surface energy of the photo-curable transfer layer 11. For example, unmodified or modified polysiloxane can be mentioned. The modified polysiloxane is preferred because it suppresses bleeding of the photo-curable components. Examples of the unmodified polysiloxane include dimethyl silicone, methyl phenyl silicone, and methyl hydrogen silicone. Examples of the modified polysiloxane include the above-mentioned polysiloxane having a functional group at side chain, one end or both ends. Examples of the functional group include an amino group, an epoxy group, a cycloaliphatic epoxy group, a carbinol group, a mercapto group, a carboxyl group, an acryloyl group and a methacryloyl group. Preferred are the modified polysiloxane, especially acryloyl group and/or methacryloyl group modified polysiloxane. The (meth)acryloyl group may bond to polysiloxane through polyalkylene oxide.

As the fluorine-atom-containing ethylenic compound as a lubricant to be added to the photo-curable composition, any fluorine-atom-containing ethylenic compound can be used as long as it is capable of adjusting the surface energy of the photo-curable transfer layer 11. Fluoro(meth)acrylates are preferred because they are capable of adjusting easily the surface energy. Examples of the fluoro(meth)acrylates include 2,2,2-trifluoroethyl acrylate, 2,2,2-trifluoroethyl methacrylate, 2,2,3,3-tetrafluoropropyl acrylate, 1$H$, 1$H$, 5$H$-octafluoropentyl acrylate, 1$H$, 1$H$, 5$H$-octafluoropentyl methacrylate.

These lubricants can be used singly or in combination of two or more kinds. The additive amount of the lubricant is appropriately adjusted depending upon the kind of lubricant so as to adjust the surface energy of the photo-curable transfer layer 11 to the range of more than 20mN/m and less than 30mN/m.

The surface energy is determined in the following manner. The contact angle of the photo-curable transfer layer is measured with a contact angle instrument (Drop-master, available from Kyowa Interface Science Co., Ltd.) using as standard solvent water, 1-bromonaphthalene and diiodomethane. The obtained value of contact angle is subjected to analysis according to a geometrical average method based on an extended Fowkes equation of Kitazaki and Hata (Yasuaki Kitazaki, Toshio Hata et. al. , Journal of The Adhesion of Japan, Vol. 8(3), 1972, pages 131-141), whereby the surface energy is obtained.

In more detail, adhesion works of the standard solvents described in the above-mentioned document and the photo-curable transfer layer are calculated by using data of surface energies of the standard solvents (set forth in Table 1) and the following equation 1.

[Table 1]

| Standard solvent | $\gamma$ (mN/m) | $\gamma^a$ (mN/m) | $\gamma^b$ (mN/m) | $\gamma^c$ (mN/m) |
|---|---|---|---|---|
| Water | 72.8 | 29.1 | 1.3 | 42.4 |
| 1-Bromonaphthalene | 44.6 | 44.4 | 0.2 | 0 |
| Diiodomethane | 50.8 | 46.9 | 4.0 | 0 |
| $\gamma$: Surface energy $\gamma$: Dispersion component (wetting caused by non polarity) $\gamma^b$: Dipole component (wetting caused by polarity) $\gamma^c$: Hydrogen bond component (wetting caused by hydrogen bond) | | | | |

[Equation 1]

$$W_{SL} = \gamma_L(1+\cos\theta)$$

$W_{SL}$:     Adhesion work between S (Solid) and L(liquid)

$\gamma_L$:     Surface energy of liquid

Subsequently, $\gamma^a$, $\gamma^b$ and $\gamma^c$ of the photo-curable transfer layer are calculated from $\gamma^a$, $\gamma^b$ and $\gamma^c$ of the standard solvents and the following equation 2, and then the surface energy ($\gamma$) of the photo-curable transfer layer is calculated from the following equation 3.

[Equation 2]

$$W_{12} = 2\sqrt{\gamma^a_1 \cdot \gamma^a_2} + 2\sqrt{\gamma^b_1 \cdot \gamma^b_2} + 2\sqrt{\gamma^c_1 \cdot \gamma^c_2}$$

$W_{12}$:     Adhesion work between substances 1 and 2

$\gamma^a_1$:     $\gamma^a$ of standard solvent

$\gamma^b_1$     $\gamma^b$ of standard solvent

$\gamma^c_1$     $\gamma^c$ of standard solvent

$\gamma^a_2$:     $\gamma^a$ of photo-curable transfer layer

$\gamma^b_2$     $\gamma^b$ of photo-curable transfer layer

$\gamma^c_2$     $\gamma^c$ of photo-curable transfer layer

[Equation 3]

$$\gamma = \gamma^a + \gamma^b + \gamma^c$$

In the invention, as the polymer film 12b of the transparent film 12, any polymer film may be used as long as it has transparency and physical properties required for the photo-curable transfer sheet of the invention. A polyester film is preferred. The polyester is generally linear saturated polyester derived from aromatic dibasic acid or ester-forming derivative thereof and diol or ester-forming derivative thereof.

Examples the polyester include polyethylene terephthalate (PET), polyethylene-2,6-naphthalate, polyethylene isophthalate, polybutylene terephthalate, poly(1,4-cyclohexylene terephthalate). Copolymers of these monomers or a blend of the polyester with other resin as an accessory component (in amount of less than 50 mol%) can be also used. Of these polyesters, polyethylene terephthalate (PET) and polyethylene-2,6-naphthalate are preferred in view of balance between mechanical properties and optical properties. Particularly, polyethylene-2,6-naphthalate has increased mechanical strength, reduced heat shrinkage and reduced amount of oligomer generated on heating, and therefore is excellent compared with polyethylene terephthalate from these viewpoints.

In the invention, though the transparent film 12 may not have the adhesion layer 12a, it is preferred to provide the adhesion layer 12a on the polymer film 12b in order to enhance adhesion between the polymer film 12b and the photo-curable transfer 11. The adhesion layer 12a preferably is a layer consisting of a polyester resin, a polyurethane resin, an acrylic resin or a mixture of two or more kinds thereof.

Subsequently, the method for forming a fine concave-convex pattern of the invention carried out by using the above photo-curable transfer sheet 10 is explained with reference to the drawings Generally, a nanoimprint method can be also carried out in the same manner as the method for forming a fine concave-convex pattern.

The schematic section views illustrating the representative embodiment of the method for forming a fine concave-convex pattern of the invention are shown in Figs. 2 and 3

First, the release sheet 13 is removed from the photo-curable transfer sheet 10, and consequently the photo-curable transfer layer 11 is exposed. The photo-curable transfer layer 11 is bonded and fixed onto an adhesive layer 12a of the transparent film 12 comprising the polymer film 12b and the adhesive layer 12a thereon. A stamper 14 as a mold is arranged on the photo-curable transfer layer 11 such that the fine concave-convex pattern of the stamper 14 faces the surface of the photo-curable transfer layer 11 (stage (a) of Fig. 2). Subsequently, the stamper 14 is depressed on the photo-curable transfer layer 11 (stage (b) of Fig. 2). The stages (a) and (b) constitute the step (1). If necessary, the photo-curable transfer layer 11 is heated to enable the depression. In case the depression can be carried out at room temperature, the heating is unnecessary. Under this condition, the photo-curable transfer layer 11 is exposed to light (UV) to cure (the step (2)). It is preferred that the exposure to light is carried out with the depression because of reduction of tact time. Then, the stamper 14 is removed (peeled) from the photo-curable transfer layer 11c (stage (c) of Fig. 2). The stage (c) constitutes the step (3). In this way, the inverted fine concave-convex pattern is formed on the photo-curable transfer layer 11, the inverted fine concave-convex pattern being obtained by inverting the fine concave-convex pattern of the stamper.

In the method of the invention, the stamper 14 is much easily removed from the cured photo-curable transfer layer 11c and a part of the cured transfer layer 11 is not transferred onto the stamper 14 because of using the photo-curable transfer sheet of the invention. Hence, it is possible to form the inverted fine concave-convex pattern having no defect and not to do damage to the stamper 14.

In case the photo-curable transfer sheet 10 having the inverted fine concave-convex pattern, which is formed by the fine concave-convex pattern of the stamper being inverted, is used as an intermediate stamper, a fine concave-convex pattern can be formed on a surface of a photo-curable resin layer 16 formed on a substrate 15.

A liquid photo-curable resin composition has been applied onto a surface of the substrate 15 and consequently the photo-curable resin layer 16 has been formed. Examples of the substrate 15 include a substrate for electronic part, and one consisting of this substrate and a wiring pattern thereon. In more detail, the examples include silicon wafer, metallic substrates such as copper, chromium, iron, aluminum, and a glass substrate.

The intermediate stamper 20 prepared above which consists of the transparent film 12 and the photo-curable transfer layer 11c having the inverted fine concave-convex pattern formed thereon is arranged on the photo-curable resin layer 16 such that the inverted fine concave-convex pattern faces the surface of the photo-curable resin layer 16 (stage (d) of Fig. 3). Subsequently, the intermediate stamper 20 is depressed on the photo-curable resin layer 16 (stage (e) of Fig. 3). The stages (d) and (e) constitute the step (4). If necessary, the photo-curable resin layer 16 is heated to enable the depression. In case the depression can be carried out at room temperature, the heating is unnecessary. Under this condition, the photo-curable resin layer 16 is exposed to light (UV) to cure (the step (5)). It is preferred that the exposure to light is carried out with the depression because of reduction of tact time. Then, the intermediate stamper 20 is removed (peeled) from the cured photo-curable resin layer 16 in which a fine concave-convex pattern is formed (stage (f) of Fig. 3). The stage (f) constitutes the step (6). In this way, the fine concave-convex pattern is formed on the cured photo-curable resin layer 16, the fine concave-convex pattern being the same as the concave-convex pattern of the stamper.

In the method of the invention, the intermediate stamper 20 is much easily peeled from the cured photo-curable resin layer 16 and a part of the cured photo-curable resin layer 16 is not transferred onto the intermediate stamper 20 because of using the photo-curable transfer sheet 10 of the invention for the intermediate stamper 20. Hence, it is possible to form the fine concave-convex pattern having no defect on the cured photo-curable resin layer 16.

Though the photo-curable resin layer 16 may be formed from the photo-curable composition deformable by application of pressure, in the same manner as the photo-curable transfer sheet 10, a liquid photo-curable resin composition for the photo-curable resin layer 16 is preferred because it can be applied in the form of thin layer onto the substrate 15. In the above-mentioned method, the photo-curable transfer sheet of the invention is particularly improved in the peeling property from the photo-curable resin layer, and hence the use of the liquid photo-curable resin composition is effective.

Generally, the steps (1) to (6) are repeated to give photo-curable transfer layers having fine concave-convex pattern. However, a great number of photo-curable transfer layers can be prepared by using the intermediate stamper 20. In more detail, after the steps (1) to (3) are carried out, the steps (4) to (6) can be repeated.

Though the above-mentioned method is explained using a stamper as the mold, it can be also carried out using other molds. A stamper used in a nanoimprint method is preferably used as the mold because it has an advantage in transfer of fine concave-convex pattern. Any can be used as material of the mold. Preferred are nickel, titanium, silicon, quartz, particularly nickel.

Fig. 4 shows a schematic section view illustrating a representative embodiment of a continuous method for forming a fine concave-convex pattern of the present invention. First, a continuous photo-curable transfer sheet 30 is delivered from a lead-on roll 36a, and a release sheet 33 is wound around a wind-up roll 36b through a guide roll 36c to be removed. A photo-curable transfer layer 31 which is bonded and fixed onto a transparent film 32 (comprising a polymer film and an adhesive layer thereon) is exposed, and transported in the direction of arrow through a guide roll 36d. When the photo-curable transfer sheet 30 comes at a UV- transmission type pressure bonding part 35 movable up and down provided with a stamper part 34 having a fine concave-convex pattern and a UV lamp 37 (i.e., between 34 and 35), it comes to a stop. At the same time of the stop, the UV- transmission type pressure bonding part 35 moves downward to push down the transparent film 32, whereas the photo-curable transfer layer 31 is depressed to the stamper part 34. After or on the depression, the photo-curable transfer layer 31 is exposed to light of the UV lamp 37 to be cured. Thereafter, the UV- transmission type pressure bonding part 35 moves upward, and at the same time the cured photo-curable transfer layer 31c is peeled from the stamper part 34. The photo-curable transfer layer 31 c has a fine concave-convex pattern formed by inversion of the fine concave-convex pattern of the stamper part 34, and may be used as an intermediate stamper.

The cured photo-curable transfer layer 31 c bonded and fixed onto the transparent film 32 is transported again. When it comes at a UV-transmission type pressure bonding part 45 movable up and down provided with a substrate 40 having a photo-curable resin layer 41 and a UV lamp 37 (i.e., between 40 and 45), it comes to a stop. The photo-curable resin layer 41 has been formed by coating a liquid photo-curable resin composition. At the same time of the stop, the UV- transmission type pressure bonding part 45 moves downward to push down the transparent film 32, whereas the photo-curable transfer layer 31c is pressed to the photo-curable resin layer 41. After or on the press, the photo-curable resin layer 41 is exposed to light of the UV lamp 47 to be cured. Thereafter, the UV-transmission type pressure bonding part 45 moves upward, and at the same time the cured photo-curable resin layer 41 is peeled from the photo-curable transfer layer 31 c. The same fine concave-convex pattern as that of the stamper part 34 is formed on the surface of the photo-curable resin layer 41, which becomes a product. The cured photo-curable transfer layer 31c bonded and fixed onto the transparent film 32 is used as an intermediate stamper, whereby a fine concave-convex pattern can be continuously formed on plural photo-curable resin layers by the process as above. Thereafter, the cured photo-curable transfer layer 31c bonded and fixed onto the transparent film 32 is wound around a wind-up roll 36f through the guide roll 36e. The transfer of the stamper part 24 to the photo-curable transfer layer 31 and the transfer of the photo-curable transfer layer 31 to the photo-curable resin layer 41 may not be carried out continuously. For example, the cured photo-curable transfer layer 31c bonded and fixed onto the transparent film 32 may be wound around a wind-up roll 35f, and then at appropriate times, the pattern of the intermediate stamper may be transferred to the photo-curable resin layer 41 to prepare a product.

The polymer film of the transparent film constituting the photo-curable transfer sheet of the invention is preferably made of polyester. Thought the polyester may be homopolymer, or copolymer copolymerized with a third component, the homopolymer is preferred. In case the basic polyester is polyethylene terephthalate, isophthalic acid copolymerized polyethylene terephthalate is most suitable. The isophthalic acid copolymerized polyethylene terephthalate preferably contains 5 mol% or less of isophthalic acid. The polyester may contain copolymerizable component other than isophthalic acid or copolymerizable alcohol component in an amount of not more than 3 mol% based on the total acid component or the total alcohol component respectively so long as the characteristics of the polyester is not damaged. Examples of the copolymerizable acid component include aromatic dicarboxylic acids such as phthalic acid and 2,6-naphthalene dicarboxylic acid; aliphatic dicarboxylic acids such as adipic acid, azelaic acid, sebacic acid, 1,10-dean dicarboxylic acid. Examples of the copolymerizable alcohol component include aliphatic diols such as 1,4-butane diol, 1,6-hexane diol, neopentyl glycol, and cycloaliphatic diols such as 1,4-cyclohexane dinethanol. These can be used singly or in combination of two or more kinds.

In case the basic polyester is polyethylene-2,6-naphthalate, naphthalene dicarboxylic acid is used as the main dicarboxylic acid component and ethylene glycol is used as the main glycol component. Examples of the naphthalene dicarboxylic acids include 2,6-naphthalene dicarboxylic acid, 2,7-naphthalene dicarboxylic acid, 1,5-naphthalene dicarboxylic acid, and 2,6-naphthalene dicarboxylic acid is preferred. The "main" of the main component means that the main component is included in the polymer in the amount of at least 90 mol%, preferably at least 95 mol% based on the total recurring units of the polymer.

In case the polyethylene-2,6-naphthalene dicarboxylate is a copolymer, any compounds having two ester-forming-functional groups in its molecule can be used as copolymerizable components constituting the copolymer. As the compounds, dicarboxylic acids such as oxalic acid, adipic acid, phthalic acid, sebacic acid, dodecane dicarboxylic acid, isophthalic acid, terephthalic acid, 1,4-cyclohexane dicarboxylic acid, 4,4'-diphenyl dicarboxylic acid, phenylindane dicarboxylic acid, 2,7-naphtalene dicarboxylic acid, tetralin dicarboxylic acid, decalin dicarboxylic acid, diphenyl ether dicarboxylic acid; oxycarboxylic acid such as p-oxybenzoic acid, p-oxyethoxybenzoic acid; and dihydric alcohols such as propylene glycol, trimethylene glycol, tetramethylene glycol, hexamethylene glycol, cyclohexane methylene glycol, neopentyl glycol, ethylene oxide adduct of bisphenol sulfone, ethylene oxide adduct of bisphenol A, diethylene glycol, polyethylene oxide glycol can be preferably used.

These compounds can be used singly or in combination of two or more kinds. Of these compounds, preferred acid components are isophthalic acid, terephthalic acid, 4,4'-diphenyl dicarboxylic acid, 2,7-naphtalene dicarboxylic acid, p-oxybenzoic acid, and the preferred glycols are trimethylene glycol, hexamethylene glycol, neopentyl glycol, ethylene oxide adduct of bisphenol sulfone.

Further, the polyethylene-2,6-naphthalene dicarboxylate may be, for example, one that a part or all of the terminal hydroxy groups and/or carboxyl groups are blocked by a mono-functional compound such as benzoic acid or methoxypolyalkylene glycol, or one that is copolymerized with a slight amount of tri or more functional ester-forming compound such as glycerol or pentaerythritol as long as a substantially linear polymer is formed.

The polyester of the invention can be obtained by conventional processes, for example, a process for directly preparing polyester having low polymerization degree by the reaction of dicarboxylic acid and glycol; or a process for preparing polyester by reacting lower alkyl ester of dicarboxylic acid with glycol by using a conventional transesterification catalyst such compounds containing sodium, potassium, magnesium, calcium, zinc, strontium, titanium, zirconium, manganese and cobalt in one kind or two or more kinds and polymerizing the reaction mixture in the presence of a polymerization catalyst. As the polymerization catalyst, antimony compounds such as antimony trioxide and antimony pentaoxide; germanium compounds such as germanium dioxide; and titanium compounds such as tetraethyl titanate, tetrapropyl titanate, tetraphenyl titanate, and partial hydrolysate thereof, and ammonium titanyl oxalate, sodium titanyl oxalate and titanium triacetyl acetonate; can be used.

In case the polymerization is carried out through transesterification, a phosphorus compound such as trimethyl phosphate, triethyl phosphate, tri-n-butyl phosphate or orthophosphoric acid is added in order to deactivate the transesterification catalyst before the polymerization. The polyethylene-2,6-naphthalene dicarboxylate preferably contains the compound in the amount of 20 to 100ppm in terms of phosphorus atom.

The polyester may be cut to tip after melt polymerization and the tip may be further subjected to solid-state polymerization in a stream of inert gas such as nitrogen.

In the invention, the polyester preferably has 90 mol% or more, further preferably 95 mol% or more, especially 97 mol% or more of ethylene-terephthalate unit or ethylene-2,6-carboxylate unit. The intrinsic viscosity of the polyester preferably is 0.40dl/g or more, further preferably 0.40 to 0.90dl/g. The use of the polyester having less than 0.40dl/g occasionally brings about a lot of cuttings in a processing, whereas the use of the polyester having more than 0.90dl/g renders melt extrusion difficult due to high melt viscosity to increase the polymerization time period which increases cost. The polyester film of the invention is required to substantially contain no particle. If the polyester contains a particle, it suffers from reduction of transparency or rough surface.

The polyester film of the invention preferably has rate of dimension change of -2 to +2%, the rate being determined at 200°C under load of 140g/mm$^2$ in a longitudinal direction. In case the rate is less than -2% or more than +2%, a laminate obtained by superposing a functional layer on the polyester film is apt to suffer from cracking or wrinkle, which occurs on or after the superposing process, and the occurrence of the wrinkle occasionally destroys the laminate whereby its function cannot be sufficiently obtained. The rate of dimension change determined at 200°C under load of 140g/mm$^2$ is more preferably -1.5 to +1.5%, further preferably -1.0 to +1.0%, especially preferably -0.5 to +0.5%. The polyester of the invention having high transparency and adhesion property has preferably haze of 1.5% or less, further preferably 1.0% or less, especially preferably 0.5% or less.

The three-dimensional center line average roughness (surface roughness) of both sides of the polyester film is preferably 0.0001 to 0.02 $\mu$m, further preferably 0.0001 to 0.015 $\mu$m, especially preferably 0.0001 to 0.010 $\mu$m. Particularly, in case the three-dimensional center line average roughness of at least one side of the polyester film is 0.0001 to 0.005 $\mu$m, the functional layer obtained by laminating it on the polyester film has extremely smooth surface. It is most preferable that the three-dimensional center line average roughness of at least one side of the polyester film is 0.0005 to 0.00 $\mu$m.

The adhesive polyester film of the invention has preferably a thickness of 1 to 500 $\mu$m, more preferably 3 to 400 $\mu$m, further preferably 6 to 300 $\mu$m, especially preferably 12 to 250 $\mu$m.

In case an adhesion layer is provided on a surface of the polymer film of the transparent film according to the invention, the adhesion layer particularly is the combination (A) of polyester resin and acrylic resin (preferably one having functional group such as an oxazoline group), and the combination (B) of polyester resin and polyurethane resin (preferably water soluble or water dispersible polyurethane).

An adhesion layer consisting of polyester resin and acrylic resin having an oxazoline group and polyalkylene oxide chain corresponding to the combination (A) is described as follows:

The polyester resin of the combination (A) preferably is polyester soluble or dispersible in water (which may contain a little organic solvent). The polyester is preferably prepared from polybasic acid or ester-forming derivative thereof and polyol or ester-forming derivative thereof, which are mentioned below.

Examples of the polybasic acid component of the polyester include terephthalic acid, isophthalic acid, phthalic acid, phthalic anhydride, adipic acid, sebacic acid, trimellitic acid, pyromellitic acid, dimer acid, and 5-sodiumsulfo isophthalic acid. Copolymerized polyester derived from materials including two or more kinds of the acid components is preferred The polyester may contain a little unsaturated polybasic acid components such as maleic acid, itaconic acid or hydroxy carboxylic acid components such as p-hydroxy benzoic acid.

Examples of the polyol component of the polyester include ethylene glycol, 1,4-butane diol, diethylene glycol, dipropylene glycol, 1,6-hexamethylene glycol, 1,4-cyclohexane dimethanol, xylylene glycol, dimethylol propane, poly (ethylene oxide) glycol, poly(tetramethylene oxide) glycol, and monomer thereof.

The acrylic resin of the combination (A) has preferably an oxazoline group and polyalkylene oxide chain. Particularly, preferred is acrylic resin soluble or dispersible in water which may contain a little organic solvent. The acrylic resin having an oxazoline group and polyalkylene oxide chain generally includes the following monomers as the components.

Examples of the monomers having an oxazoline group include 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline and 2-isopropenyl-5-methyl-2-oxazoline. The monomer can be used singly or in the combination of two or more kinds. Of these monomers, 2-isopropenyl-2-oxazoline is preferred because it is easily available industrially. The use of the acrylic resin having an oxazoline group brings about enhancement of cohesion force of the coated layer to increase the adhesion to a transfer layer. Further, examples of the monomers having polyalkylene oxide chain include acrylate or methacrylate obtained by adding polyalkylene oxide to the ester residue of the acrylate or methacrylate. Examples of the polyalkylene oxide chain include polymethylene oxide, polyethylene oxide, polypropylene oxide, and polybuylene oxide. The number of the recurring unit of polyalkylene oxide chain preferably is 3 to 100. The acrylic resin having polyalkylene oxide chain is improved in compatibility with polyester resin compared with acrylic resin having no polyalkylene oxide chain, whereby the adhesion layer is enhanced in transparency. The acrylic resins having the number of the recurring unit of polyalkylene oxide chain of less than 3 is reduced in compatibility with polyester resin to reduce transparency of the adhesion layer, whereas the acrylic resins having the number of the recurring unit of more than 100 renders resistance to moist heat of the adhesion layer insufficient to reduce adhesion property to a transfer layer under high humidity and high temperature.

Examples of monomers as the other copolymerizable components of the acrylic resin include alkyl acrylate and methacrylate (examples of alkyl including methyl group, ethyl group, n-propyl group, isopropyl group, n-butyl group, isobutyl group, t-butyl group, 2-ethylhexyl group, cyclohexyl group); hydroxy-containing monomers such as 2-hydroxyethyl acrylate, 2-hydroxyethyl methacrylate, 2-hydroxypropyl acrylate, 2-hydroxypropyl methacrylate; epoxy-group-containing monomers such as glycidyl methacrylate, glycidyl methacrylate and allyl glycidyl ether; monomers having carboxyl group (e.g., acrylic acid, methacrylic acid, itaconic acid, maleic acid, fumaric acid crotonic acid, styrene sulfonic acid) and salts thereof (e.g., sodium salt, potassium salt, ammonium salt, tertiary amine salt); monomers having amide group such as acrylamide, methacrylamide N-alkyl acrylamide, N-alkyl methacrylamide, N,N-dialkyl acrylamide, N,N-dialkyl methacrylamide (examples of alkyl including methyl group, ethyl group, n-butyl group, isobutyl group), acryloyl morpholine, N-methylol acrylamide, N-methylol methacrylamide, N-phenyl acrylamide, N-phenyl methacrylamide; acid anhydride monomers such as maleic anhydride and itaconic anhydride; other monomers such as vinyl isocyanate, allyl isocyanate, styrene, $\alpha$-methylstyrene, vinyl methyl ether, vinyl ethyl ether, vinyl trialkoxy silane, alkyl maleic acid monoester, alkyl fumaric acid monoester, alkyl itaconic acid monoester, acrylonitrile, methacrylonitrile, vinylidene chloride, ethylene, propylene, vinyl chloride, vinyl acetate, butadiene.

The content of the polyester for forming the adhesion layer in the adhesion layer is preferably 5 to 95% by weight, especially 50 to 90% by weight. The content of the acrylic resin having an oxazoline group and polyalkylene oxide chain for forming the adhesion layer in the adhesion layer is preferably 5 to 90% by weight, especially 10 to 50% by weight. In case the content of the polyester is more than 95% by weight or the content of the acrylic resin having an oxazoline group and polyalkylene oxide chain is less than 5% by weight, the resultant coated layer shows reduction of cohesion force to occasionally render adhesion property to a transfer layer insufficient. In contrast, in case the content of the acrylic resin having an oxazoline group and polyalkylene oxide chain is more than 90% by weight, the resultant adhesion layer shows reduced adhesion property to the polyester film to occasionally render adhesion property to a transfer layer insufficient.

The adhesion layer preferably contains 0.5 to 30% by weight, further preferably 1 to 10% by weight, of aliphatic wax. When the amount of the wax is less than 0.5% by weight, the surface of the film occasionally does not show lubricating property. In contrast, when the amount of the wax is more than 30% by weight, the resultant adhesion layer occasionally does not show adhesion property to the polymer film, or a hard coat or adhesive.

Examples of the aliphatic wax include plant derived waxes such as carnauba wax, candelilla wax, rice wax, Japan wax, jojoba oil, palm wax, rosin modified wax, ouricury wax, sugar (sugar cane) wax, esparto wax and bark wax; animal derived waxes such as beeswax, lanolin, spermaceti wax, insect wax (Ibotaro) and shellac wax; mineral derived waxes such as montan wax, ozocerite and ceresin wax; petroleum derived waxes such as paraffin wax, microcrystalline wax and petrolatum; and synthetic hydrocarbon waxes such as fischer-tropsch wax, polyethylene wax, oxidized polyethylene wax, polypropylene wax and oxidized polypropylene wax. Carnauba wax, paraffin wax and polyethylene wax are preferred because they have good adhesion property and lubrication property to a hard coat or adhesive. Particularly, the water dispersion of the wax is preferred in view of environmental problems and handling.

The adhesion layer preferably contains filler having mean particle size of 0.005 to 0.5 $\mu$m in the amount of 0.1 to 20% by weight. When the coated layer contains the filler in the amount of less than 0.1 % by weight, the film shows poor lubricating property to occasionally render winding of the film in the form of roll difficult. In contrast, when the coated layer contains the filler in the amount of more than 20% by weight, the coated layer shows reduced transparency to occasionally render the use for a display impossible.

Examples of the filler include inorganic fine particles such as calcium carbonate, magnesium carbonate, calcium oxide, zinc oxide, magnesium oxide, silicon oxide, sodium silicate, aluminum hydroxide, iron oxide, zirconium oxide, barium sulfate, titanium oxide, tin oxide, antimony trioxide, carbon black, molybdenum disulfide; organic fine particles such as acrylic crosslinked polymer, styrene crosslinked polymer, silicon resin, fluoro resin, benzoguanamine resin, phenol resin, nylon resin and polyethylene wax. Of these fillers, super fine particles having specific weight of not more than 3 are preferably selected in order to prevent the sedimentation in the water dispersion.

A coating liquid of the combination (A) for coating the adhesion layer is preferably used in the form of an aqueous solution, a water dispersion or an emulsion. For forming the coated layer, if necessary, it is possible to add other resins, an antistatic agent, a coloring agent, a surface-active agent and an ultraviolet ray absorber except the above-mentioned components. Particularly, the addition of a lubricant enables enhancement of lubricating property and blocking resistance.

The coating liquid can be applied onto the polyester film in an optional stage. However, it is preferred to carry out the application in the process of preparing the polyester film, and further preferred to carry out the application to the polyester film before the completion of orientational crystallization. The polyester film before the completion of orientational crystallization includes a unoriented film, a uniaxially-oriented film obtained by orienting a unoriented film in a longitudinal or crosswise direction, and a diaxially-oriented film obtained by orienting a unoriented film in longitudinal and crosswise directions (i.e., two directions) in low magnification ratio (therefore the diaxially-oriented film being further oriented in a longitudinal or crosswise direction to complete orientational crystallization). Particularly, it is preferred that the unoriented film or the uniaxially-oriented film is coated with the aqueous coating liquid as above, and directly subjected to orientation in longitudinal and/or crosswise directions and heat fixation.

In the application of the coating liquid onto the film, it is preferred to subject the surface of the film to physical treatments such as corona treatment, flame treatment and plasma treatment as preliminary treatment, or to combine the treatment with the coating liquid containing a surface active agent which is chemically inactive to the liquid.

Conventional coating methods can be used as the coating method. Examples of the coating method include roll coating method, gravure-roll method, roll brush method, spray coating method, air knife coating method, impregnation method, curtain coating method and the combination thereof.

The adhesion layer of the invention also comprises preferably the combination (B) of the above-mentioned polyester resin (preferably copolymerized polyester) and polyurethane resin (preferably water-soluble, water-dispersible polyurethane). The copolymerized polyester shows excellent adhesion to a polymer film such as polyester film, but occasionally poor adhesion to a transfer layer. In contrast, the polyurethane resin shows excellent adhesion to the transfer layer but occasionally poor adhesion to the polymer film such as polyester film. Therefore the combination is preferred.

The copolymerized polyester of the combination (B) has as components dicarboxylic acid component and branched glycol component. Examples of the branched glycol component include 2,2-dimethyl-1,3-propane diol, 2-methyl-2-ethyl-1,3-propane diol, 2-methyl-2-butyl-1,3 -propane diol, 2-methyl-2-propyl-1,3-propane diol, 2-methyl-2-isopropyl-1,3-propane diol, 2-methyl-2-n-hexyl-1,3-propane diol, 2,2-diethyl-1,3-propane diol, 2-ethyl-2-n-butyl-1,3-propane diol, 2-ethyl-2-n-hexyl-1,3-propane diol, 2,2-di-n-butyl-1,3-propane diol, 2-n-butyl-2-propyl-1,3-propane diol and 2,2-di-n-hexyl-1,3-propane diol.

The branched glycol component is preferably contained in the amount of not less than 10 mol%, further preferably not less than 20mol% based on the total glycol component. The glycol component other than the branched glycol component is most preferably ethylene glycol. Diethylene glycol, propylene glycol, butane diol, hexane diol, or 1,4-cyclohexane dimethanol can be used, provided that they are used in a little amount,.

The dicarboxylic acid component contained as constituent in the copolymerized polyester is most preferably terephthalic acid and isophthalic acid. Other carboxylic acids, for example, aromatic dicarboxylic acid such as diphenyl carboxylic acid and 2,6-naphthalene dicarboxylic acid can be copolymerized, provided that they are used in a little amount. In addition to the above dicarboxylic acids, 5-sulfoisophthalic acid is preferably used in the range of 1 to 10 mol% in order to give water dispersibility, and other than 5-sulfoisophthalic acid, sulfoterephthalic acid, 4-sulfonaphthalene isophthalic acid-2,7-dicarboxylc acid and 5-(4-sulfophenoxy)isophthalic aid, and salts thereof can be used.

The polyurethane resin used in the combination (B) is, for example, resin containing block type isocyanate group such as thermal-reactive water-soluble urethane resin having terminal isocyanate group blocked by a hydrophilic group or the like. Examples of the blocking agent (protecting agent) for the isocyanate group include bisulfate salts, and sulfonic acid group-containing phenols, alcohols, lactams, oximes and active methylene compounds. The blocked isocyanate group renders the urethane prepolymer hydrophilic or water-soluble. When the resin is heated in a drying or thermosetting process in the film preparation, the blocking agent is removed from the isocyanate group, whereby the resin is self-crossliked to form a mesh structure. The water-dispersible copolymerized polyester is fixed on the mesh structure and simultaneously reacted with the terminal group or the like of the resin. The resin in the coating liquid has poor water resistance due to its hydrophilic property. However, after the completion of the coating, drying, thermosetting and thermo reaction, the hydrophilic group (i.e., blocking agent) of the urethane resin is removed, and hence the coated layer shows excellent water resistance.

Of the blocking agents, bisulfate salts are most preferable because of appropriate heat treatment temperature and time period, and widely used in industry. The chemical composition of the urethane prepolymer used in the urethane resin comprises a compound having terminal isocyanate group obtained by the reaction of (1) a compound having two or more active hydrogen atoms in its molecule, or having molecular weight of 200-20000 and two or more active hydrogen atoms in its molecule, (2) an organic polyisocyanate having two or more isocyanate groups in its molecule, or (3) a chain extender having two or more active hydrogen atoms in its molecule.

The (1) compound mentioned above generally contains two or more hydroxy groups, carboxyl groups, amino groups or mercapto groups in its terminal or molecule, and the particularly preferred compound is polyether polyol or polyetherester polyol. Examples of the polyether polyol include compounds obtained by the polymerization of alkylene oxide such as ethylene oxide and propylene oxide, or styrene oxide and epichlorohydrin, or by the random polymerization or block polymerization thereof, or by addition polymerization thereof to polyhydric alcohol.

Polyester polyol and polyetherester polyol generally are in the form of straight chain or branched chain. They can be obtained by the condensation of polybasic saturated or unsaturated acids such as succinic acid, adipic acid, phthalic acid and maleic acid anhydride or anhydrides thereof, with polyhydric saturated or unsaturated alcohols such as ethylene glycol, diethylene glycol, 1,4-butane diol, neopentyl glycol, 1,6-hexanediol and trimethylolpropane, polyalkylene ethers such as polyethylene glycol and polypropylene glycol having relatively low molecular weight, or a mixture thereof.

Also, polyesters obtained from lactone and hydroxy acid can be used as the polyester polyol, and polyetherester polyols obtained by adding ethylene oxide or propylene oxide to polyester prepared preliminarily can be used as the polyetherester polyol.

Examples of the (2) organic polyisocyanate mentioned above include aromatic diisocyanates such as isomers of tolylene diisocyanate and 4,4-diphenylmethane diisocyanate, aromatic aliphatic diisocyanates such as xylylene diisocyanate, cycloaliphatic diisocyanates such as isophorone diisocyanate and 4,4-dicyclohexylmethane diisocyanate, aliphatic diisocyanates such as hexamethylene diisocyanate and 2,2,4-trimethylhexamethylene diisocyanate, or polyisocyanate obtained by adding one or plurality of these compounds to trimethylol propane.

Examples of the (3) chain extender having two or more active hydrogen atoms mentioned above include glycols such as ethylene glycol, diethylene glycol, 1,4-butane diol andl,6-hexanediol, polyhydric alcohols such as glycerol, trimethylolpropane and pentaerythritol, diamines such as ethylene diamine, hexamethylene diamine, and piperazine, aminoalcohols such as monoethanol amine and diethanol amine, thiodiglycol such as thiodiethylene glycol, and water.

The urethane prepolymer can be generally synthesized by one-step or multi-step isocyanate poly-addition method using the chain extender under the reaction conditions of 150°C or less, preferably 70 to 120°C for 5 minutes to several hours. Although a ratio of isocyanate group to active hydrogen can be freely selected in the range of 1 or more, the resultant urethane prepolymer is required to have free isocyanate group. Further, the content of the free isocyanate group generally is not more than 10% by weight, whereas the content of the free isocyanate group preferably is not more than 7% by weight in view of the stability of an aqueous solution of urethane polymer blocked later.

The resultant urethane prepolymer is preferably blocked by using bisulfate salts. The reaction is carried out by mixing it with an aqueous solution of bisulfate salt, and stirring sufficiently the mixture for 5 minutes to 1 hour to proceed the reaction. The reaction temperature is preferably not more than 60°C. Thereafter, the reaction mixture is diluted with water to an appropriate concentration to form a thermo-reaction type water-soluble urethane composition. The composition is adjusted to appropriate concentration and viscosity when it is used. However, in case the composition is heated at approx. 80 to 100°C, the bisulfate salt of blocking agent dissociates to regenerate an active isocyanate group. Therefore the resultant composition has the properties that polyaddition reaction occurring within molecule or between molecules brings about formation of polyurethane polymer or addition to other functional groups.

As one example of resin having blocked isocyanate group, Erastron available from Dai-ichi Kogyo Seiyaku Co., Ltd. can be typically mentioned. The Erastron is prepared by blocking isocyanate groups with sodium bisulfate and provided with a carbamoyl sulfonate group having strong hydrophilic property, and hence the Erastron is soluble in water.

In case the copolymerized polyester resin containing branched glycol component (a) and the resin containing blocked isocyanate group (b), which are used in the combination (B), are mixed with each other to prepare a coating liquid, a ratio by weight of the resin (a) and the resin (b) is preferably (a):(b)=90:10 to 10:90, further preferably (a):(b) =80:20 to 20:80. When the ratio of the resin (a) to the solid content is less than 10% by weight, coating properties on a polymer film becomes poor and adhesion between the film and a surface layer is insufficient. When the ratio of the resin (b) to the solid content is less than 10% by weight, adhesion to a transfer layer is insufficient to be of no practical use.

The coating liquid of the combination (B) is preferably an aqueous liquid. In case the coating liquid is applied onto the polymer film mentioned above, known anionic surface active agents and nonionic surface active agents can be added in necessary amount to the liquid. Solvents used in the liquid include in addition to water, alcohols such as ethanol, isopropyl alcohol and benzyl alcohol, and the alcohols may be contained in the total coating liquid up to less than 50% by weight. Further organic solvents other than alcohols may be contained in the amount of less than 10% by weight as long as it is soluble. However, the total amount of the alcohols and the other organic solvent is less than 50% by weight based on the coating liquid.

When the added amount of the organic solvent is less than 50% by weight, drying property of the coated layer is enhanced and simultaneously the appearance of the coated layer is also improved compared with that formed from a coating liquid containing only water. When the added amount of the organic solvent is not less than 50% by weight, the solvent vaporizes in high speed to bring about the variation of the concentration of the coated layer, whereby the viscosity of the coated layer increases to bring about occasionally poor appearance of the coated layer, and further to increase risk of occurrence of a fire.

The adhesion layer of the invention generally is in the range of 0.01 to 0.3 $\mu$m, especially 0.02 to 0.2 $\mu$m.

The photo-curable composition for forming the photo-curable transfer layer of the photo-curable transfer sheet of the invention preferably comprises a polymer. Examples of the polymer (preferably one having glass transition temperature of not less than 80°C) include an acrylic resin, a polyvinyl acetate, a vinyl acetate/ (meth)acrylate copolymer, an ethylene/vinyl acetate copolymer, a polystyrene and copolymer thereof, a polyvinyl chloride and copolymer thereof, a butadiene/acrylonitrile copolymer, an acrylonitrile/butadiene/styrene copolymer, a methacrylatelacrylonitrilelbutadiene/ styrene copolymer, 2-chlorobutadiene-1,3-polymer, a chlorinated rubber, a styrene/butadiene/styrene copolymer, a styrene/isoprene/styrene block copolymer, an epoxy resin, a polyamide, a polyester, a polyurethane, a cellulose ester, a cellulose ether, a polycarbonate, a polyvinyl acetal.

In the invention, the polymer preferably is an acrylic resin in view of excellent transferring property and high curing property. Especially preferred is an acrylic resin having a polymerizable functional group or an acrylic resin having a hydroxyl group as mentioned above. The acrylic resin preferably has a recurring unit of methyl methacrylate in the amount of not less than 50% by weight, especially 60 to 90% by weight, because the glass transition temperature of not less than 80°C are easily obtained and excellent transferring property and high curing property are also easily obtained. As the acrylic resin having a polymerizable functional group, for example, POREAS-7 (manufactured by Osaka Organic Chemical Industry Ltd.) can be preferably used.

The acrylic resin having a polymerizable functional group generally is a copolymer of methyl methacrylate, at least one alkyl (meth)acrylate whose alkyl has 2 to 10 carbon atoms and glycidyl (meth)acrylate, the glycidyl group being reacted with carboxylic acid having a photopolymerizable functional group; or a copolymer of methyl methacrylate, at least one alkyl (meth)acrylate whose alkyl has 2 to 10 carbon atoms and carboxylic acid having a photopolymerizable functional group, a carboxyl group of the carboxylic acid being reacted with glycidyl (meth)acrylate.

The copolymer of methyl methacrylate, at least one alkyl (meth)acrylate whose alkyl has 2 to 10 carbon atoms and glycidyl (meth)acrylate or carboxylic acid having a photopolymerizable functional group, preferably has at least 50% by weight of recurring unit of methyl methacrylate, especially 60 to 90% by weight of recurring unit of methyl methacrylate. An appropriate combination of the acrylic resin with the reactive diluent enables the achievement of both of excellent transferring property and high curing property. Examples of the alkyl (meth)acrylate whose alkyl has 2 to 10 carbon atoms (especially 3 to 5 carbon atoms) include ethyl (meth)acrylate, n-propyl (meth)acrylate, isopropyl (meth)acrylate, n-butyl (meth)acrylate, isobutyl (meth)acrylate, 2-ethylhexyl (meth)acrylate. Preferred are n-butyl (meth)acrylate, isobutyl (meth)acrylate, 2-ethylhexyl (meth)acrylate. The alkyl (meth)acrylate is preferably contained as recurring unit in the amount of 5 to 30% by weight, especially 10 to 30% by weight, in the polymer. The glycidyl (meth)acrylate or carboxylic acid having a photopolymerizable functional group is preferably contained as recurring unit in the amount of 5 to 25% by weight, especially 5 to 20% by weight, in the polymer. The glycidyl group or carboxyl group of the resultant copolymer is reacted with carboxylic acid having a photopolymerizable functional group or glycidyl (meth)acrylate, respectively.

The acrylic resin having hydroxyl group generally is a copolymer of methyl methacrylate, at least one alkyl (meth)acrylate whose alkyl has 2 to 10 carbon atoms (especially 3 to 5 carbon atoms) and at least one hydroxyalkyl (meth)acrylate whose hydroxyalkyl has 2 to 4 carbon atoms. The methyl methacrylate is preferably contained as recurring unit in the amount of at least 50% by weight, especially 60 to 90% by weight in the polymer. An appropriate combination of the acrylic resin with the reactive diluent enables the achievement of both of excellent transferring property and high curing property. Examples of the alkyl (meth)acrylate whose alkyl has 2 to 10 carbon atoms (especially 3 to 5 carbon atoms) include ethyl (meth)acrylate, n-propyl (meth)acrylate, isopropyl (meth)acrylate, n-butyl (meth)acrylate, isobutyl (meth)acrylate, 2-ethylhexyl (meth)acrylate. Preferred are n-butyl (meth)acrylate, isobutyl (meth)acrylate, 2-ethylhexyl (meth)acrylate. The alkyl (meth)acrylate is preferably contained as recurring unit in the amount of 5 to 30% by weight, especially 10 to 30% by weight, in the polymer. Examples of the hydroxyalkyl (meth)acrylate whose hydroxyalkyl has 2 to 4 carbon atoms include 2-hydroxyethyl methacrylate, hydroxypropyl methacrylate. The hydroxyalkyl (meth)acrylate is preferably contained as recurring unit in the amount of 5 to 25% by weight, especially 5 to 20% by weight, in the polymer.

The acrylic resin having a polymerizable functional group is, for example, prepared as follows:

One or plural (meth)acrylate(s) (preferably methyl methacrylate and at least one alkyl (meth)acrylate whose alkyl has 2 to 10 carbon atoms as mentioned above) is reacted with a compound having a glycidyl group and a photopolymerizable functional group (preferably glycidyl (meth)acrylate), or with a carboxylic acid having a photopolymerizable functional group in the presence of a radical polymerization initiator and an organic solvent according to a known polymerization process such as a solution polymerization process, whereby glycidyl group-containing acrylic resin (a) or carboxyl group-containing acrylic resin (b) is obtained. The alkyl (meth)acrylate is preferably contained in the amount of 10 to 45% by weight in terms of solid based on the glycidyl group-containing acrylic resin (a) or carboxyl group-containing acrylic resin (b).

Subsequently, carboxylic acid having a photopolymerizable functional group is added to the glycidyl group-containing acrylic resin (a), or a compound having a glycidyl group and a photopolymerizable functional group (preferably glycidyl (meth)acrylate) is added to the carboxyl group-containing acrylic resin (b), with if necessary heating to prepare an acrylic photocurable resin (A) or an acrylic photocurable resin (B). A molar ratio of carboxyl group to glycidyl group is generally 1/0.9 to 1/1, preferably 1/1. Excess glycidyl group may bring about disadvantages in long-term stability such as increase of viscosity or gelation, whereas excess carboxyl group reduces workability due to increase of skin irritation. Further, the ratio of 1/1 brings about disappearance of glycidyl group to extremely enhance storage stability. The reaction can be carried out according to known methods in the presence of base catalyst or phosphorous catalyst.

The (meth)acrylate monomers as chief ingredient of the acrylic resin used in the invention, the acrylic resin including the acrylic resin having a photopolymerizable functional group or hydroxyl group, include various esters of acrylic acid or methacrylic acid. Examples of the esters of acrylic acid or methacrylic acid include alkyl(meth)acrylates [the (meth)acrylate means acrylate and methacrylate, hereinafter in the same manner] such as methyl (meth)acrylate, ethyl (meth)acrylate, n-propyl (meth)acrylate, n-butyl (meth)acrylate, isobutyl (meth)acrylate, t-butyl (meth)acrylate, 2-ethylhexyl (meth)acrylate, stearyl (meth)acrylate, lauryl (meth)acrylate and tridecyl (meth)acrylate; alkoxyalkyl(meth) acrylates such as ethoxyethyl(meth)acrylate and butoxyethyl(meth)acrylate; alkoxyalkoxyalkyl(meth)acrylates such as 2-methoxyethoxyethyl(meth)acrylate and 2-ethoxyethoxyethyl (meth)acrylate; alkoxy (poly)alkylene glycol (meth)acrylates such as methoxy diethylene glycol (meth)acrylate, ethoxy diethylene glycol (meth)acrylate, methoxy triethylene glycol (meth)acrylate, butoxy triethylene glycol (meth)acrylate and methoxy dipropylene glycol (meth)acrylate; dialkylaminoalkyl(meth)acrylates such as pyrenoxide adduct (meth)acrylates, N,N-dimethylaminoethyl (meth)acrylate and N,N-diethylaminoethyl (meth)acrylate. Further there can be mentioned aromatic compounds having unsaturated group (e.g., styrene).

In the invention, it is preferred to use methyl methacrylate and at least one alkyl (meth)acrylate whose alkyl has 2 to 10 carbon atoms as the main integrants of the (meth)acrylate monomer of the acrylic resin as mentioned above.

The polymer (preferably one having a glass transition temperature of not less than 80°C), preferably has number average molecular weight of not less than 100,000, especially 100,000 to 300,000, and weight average molecular weight of not less than 100,000, especially 100,000 to 300,000.

As the polymer having a glass transition temperature of not less than 80°C of the invention, acrylic resin having both of a photopolymerizable functional group and a functional group containing an active hydrogen such as a hydroxyl group can be also used. Such reactive polymer generally is a homopolymer or copolymer (i.e., acrylic resin) which is obtained from the above-mentioned (meth)acrylates and which has a photopolymerizable functional group and a functional group having active hydrogen in its main chain or side chain. Hence the homopolymer or copolymer can be obtained, for example, by copolymerizing methyl methacrylate, one or more (meth)acrylate mentioned above with (meth) acrylate (e.g., 2-hydroxyethyl (meth)acrylate) having a functional group such as a hydroxyl group, and reacting the resultant polymer with a compound (e.g., isocyanatoalkyl (meth)acrylate) having a functional group capable of reacting with the active hydrogen-containing group of the polymer and having a photopolymerizable functional group. In the latter reaction, the amount of the compound (e.g., isocyanatoalkyl (meth)acrylate) having a functional group capable of reacting with the hydroxyl group is adjusted so as to leave the hydroxyl group. Thus, the polymer having the photopolymerizable functional group and the hydroxyl group as the active hydrogen-containing group can be obtained.

Otherwise, the use of (meth)acrylate (e.g., 2-aminoethyl (meth)acrylate) having an amino group instead of the hydroxyl group in the reaction results in a polymer having the photopolymerizable functional group and the amino group as the active hydrogen-containing group. Similarly a polymer having the photopolymerizable functional group and a carboxyl group as the active hydrogen-containing group can be obtained.

In the invention, it is also preferred to use acrylic resin having a photopolymerizable group through urethane bond.

The polymer having both of a photopolymerizable functional group has generally 1 to 50% by mole, preferably 5 to 30% by mole of the photopolymerizable functional group. Examples of the photopolymerizable functional group preferably include acryloyl, methacryloyl and vinyl groups, especially acryloyl and methacryloyl groups.

Examples of the reactive diluent (monomer and oligomer) having a photopolymerizable functional group, which is contained in the photo-curable composition, include,

(meth)acrylate monomers such as 2-hydroxyethyl (meth)acrylate, 2-hydroxypropyl (meth)acrylate, 4-hydroxybutyl (meth) acrylate, 2-hydroxy-3-phenyloxypropyl (meth)acrylate, 2-ethylhexyl (meth)acrylate, 2-ethylhexylpolyethoxy (meth)acrylate, benzyl (methacrylate, isobornyl (meth)acrylate, phenyloxyethyl (meth)acrylate, tricyclodecane mono(meth)acrylate, dicyclopentenyloxyethyl (meth)acrylate, tetrahydrofurfuryl (meth)acrylate, acryloylmorpholine, N-vinylcaprolactam, o-phenylphenyloxyethyl (meth)acrylate, 2-hydroxy-3-acryloyloxypropyl methacrylate, neopentylglycol di(meth)acrylate, neopentyl glycol dipropoxy di(meth)acrylate, neopentyl glycol hydroxypivalate di(meth) acrylate, tricyclodecanedimethylol di(meth)acrylate, 1,6-hexanediol di(meth)acrylate, nonanediol di(meth)acrylate, glycerol diacrylate, glycerol acrylate methacrylate, glycerol dimethacrylate, trimethylolpropane diacrylate, trimethylolpropane acrylate methacrylate, trimethylolpropane dimethacrylate, trimethylolpropane tri(meth)acrylate, pentaerythritol tri(meth)acrylate, pentaerythritol tetra(meth)acrylate, tris[(meth) acryloxyethyl]isocyanurate and ditrimethylolpropane tetra(meth)acrylate; and the following (meth)acrylate oligomer such as:

polyurethane (meth)acrylate such as compounds obtained by reaction of:

a polyol compound (e.g., polyol such as ethylene glycol, propylene glycol, neopentyl glycol, 1,6-hexanediol, 3-methyl-1,5-pentanediol, 1,9-nonanediol, 2-ethyl-2-butyl-1.3-propanediol, trimethylolpropane, diethylene glycol, dipropylene glycol, polypropylene glycol, 1,4-dimethylolcyclohexane, bisphenol-A polyethoxydiol and polytetramethylene glycol; polyesterpolyol obtained by reaction of the above-mentioned polyol and polybasic acid or anhydride thereof such as succinic acid, maleic acid, itaconic acid, adipic acid, hydrogenated dimer acid, phthalic acid, isophthalic acid and terephthalic acid; polycaprolactone polyol obtained by reaction of the above-mentioned polyol and $\varepsilon$-caprolactone; a compound obtained by reaction of a reaction product of the above-mentioned polyol and the above-mentioned polybasic acid or anhydride thereof and $\varepsilon$-caprolactone; polycarbonate polyol; or polymer polyol), and
an organic polyisocyanate compound (e.g., tolylene diisocyanate, isophorone diisocyanate, xylylene diisocyanate, diphenylmethane-4,4'-diisocyanate, dicyclopentanyl diisocyanate, hexamethylene diisocyanate, 2,4,4'-trimethylhexamethylene diisocyanate, 2,2',4'-trimethylhexamethylene diisocyanate), and
hydroxyl-containing (meth)acrylate (e.g., 2-hydroxyethyl (meth)acrylate, 2-hydroxyropyl (meth)acrylate, 4-hydroxybutyl (meth)acrylate, 2-hydroxy-3-phenyloxypropyl (meth)acrylate, cyclohexane-1,4-dimethylolmono (meth)acrylate, pentaerythritol tri(meth)acrylate or glycerol di(meth)acrylate);
bisphenol-type epoxy(meth)acrylate obtained by reaction of bisphenol-A epoxy resin or bisphenol-F epoxy resin and (meth)acrylic acid.

These compounds having photopolymerizable functional group can be employed singly or in combination of two or more kinds.

In the photo-curable composition of the invention, a ratio by weight of the polymer to the reactive diluent is preferably in the range of 20:80 to 80:20, especially in the range of 30:70 to 70:30.

Any known photopolymerization initiators can be used in the invention. The initiators having good storage-stability after mixing with other integrants are preferred. Examples of the photopolymerization initiators include acetophenone type initiators; benzoin type initiators such as benzylmethylketal; benzophenone type initiators; thioxanthone type initiators such as isopropylthioxanthone and 2,4-diethythioxanthone. Further, as special type, there can be mentioned methylphenylglyoxylate. Especially preferred are 2-hidroxy-2-methyl-1-phenylpropane-1-on, 1-hydroxycyclohexylphenylketone, 2-methyl-1-[4-(methylthio)phenyl]-2-morphorinopropane-1 and benzophenone. These photopolymerization initiators can be employed together with one or more kinds of a photopolymerization promoter such as a benzoic acid type compound (e.g., 4-dimethylaminobezoic acid) or a tertiary amine compound by mixing the initiator with the promoter in optional ratio. The initiator can be employed singly or in combination of two or more kinds. The initiator is preferably contained in the photo-curable composition (nonvolatile content) in the range of 0.1 to 20% by weight, especially 1 to 10% by weight.

Of the above-mentioned photopolymerizable initiators, examples of the acetophenone type initiator include 4-phenoxydichloroacetophenone, 4-t-butyldichloroacetophenone, 4-t-butyltrichloroacetophenone, diethoxyacetophenone, 2-hydroxy-2-methyl-1-phenylpropane-1-on, 1-(4-isopropylphenyl)-2-hidroxy-2-methylpropane-1-on, 1-(4-dodecylphenyl)-2-hydroxy-2-methylpropane-1-on, 4-(2-hydroxyethoxy)-phenyl(2-hydroxy-2-propyl)ketone, 1 -hydroxycyclohexylphenylketone, 2-methyl-1-[4-(methylthio)phenyl]-2-morphorino-propane-1-on; and examples of the benzophenone type initiator include benzophenone, benzoylbenzoic acid, methyl benzoylbenzoate, 4-phenylbenzophenone, hydroxybenzophenone, 4-benzoyl-4'-methylphenylsulfide and 3,3'-dimethyl-4-methoxybenzophenone.

The acetophenone type initiators especially are 2-hydroxy-2-methyl-1-phenylpropane-1-on, 1-hydroxycyclohexylphenylketone and 2-methyl-1-[4-(methylthio)phenyl]-2-morphorinopropane-I, and the benzophenone type initiators preferably are benzophenone, benzoylbenzoic acid and methyl benzoylbenzoate.

Preferred examples of the tertiary amine compounds of the photopolymerization promoter include triethanolamine, methyldiethanolamine, triisopropanolamine, 4,4'-dimethylaminobenzophenone, 4,4'-diethylaminobenzophenone, ethyl 2-dimethylaminobenzonate, ethyl 4-dimethylaminobenzonate, (n-butoxy)ethyl 4-dimethylaminobenzonate, isoamyl 4-dimethylaminobenzonate and 2-ethylhexyl 4-dimethylaminobenzonate. Especially preferred are ethyl 4-dimethylaminobenzonate, (n-butoxy)ethyl 4-dimethylaminobenzonate, isoamyl 4-dimethylaminobenzonate and 2-ethylhexyl 4-dimethylaminobenzonate.

Examples of diisocyanate usable in the photo-curable composition of the invention include tolylene diisocyanate (TDI), isophorone diisocyanate, xylylene diisocyanate, diphenylmethane-4,4'-diisocyanate, dicyclopentyl diisocyanate, hexamethylene diisocyanate, 2,4,4-trimethylhexamethylene diisocyanate, 2,2,4-trimethylhexamethylene diisocyanate. Further three or more functional isocyanate compounds such as TDI adduct of trimethylol propane and hexamethylene diisocyanate adduct of trimethylol propane can be employed. Of these compounds, hexamethylene diisocyanate adduct of trimethylol propane is preferred.

The diisocyanate is preferably contained in the amount of 0.2 to 4% by weight, especially 0.2 to 2% by weight in the photo-curable composition, which results in appropriate crosslinking of the transfer layer to prevent the transfer layer from exudation with maintaining good transfer property between the transfer layer and the concavo-convex surface of the mold such as a stamper. The reaction of the diisocyanate with the polymer gradually progresses after the provision of the transfer layer, for example, progresses to a large degree at a room temperature (generally 25°C) for 24 hours. Also it is considered that the polymer and diisocyanate in a coating solution for forming the transfer layer are slightly reacted with each other during the term from its preparation to its coating. Because it is preferred that the transfer layer is cured to some degree between the provision of the transfer layer and the rolling up of the resultant transfer layer, the curing of transfer layer may be promoted by heating during or after of the provision of the transfer layer, or before the rolling up.

The photo-curable composition of the invention preferably contains further, if desired, the following thermoplastic resin and other additives.

As other additives, a silane coupling agent (adhesion promoter) can be used. Examples of the silane coupling agent include vinyltriethoxysilane, vinyltris(β-methoxyethoxy)silane, γ-methacryloxypropylmethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, γ-chloropropylmethoxysilane, vinyltrichlorosilane, γ-mercaptopropylmethoxysilane, γ-aminopropyltriethoxysilane, N-β-(aminoethyl)-γ-aminopropyltrimethoxysilane. The silane coupling agent can be used singly, or in combination of two or more kinds. The silane coupling agent is preferably used in the range of 0.01 to 5 weight by part based on 100 parts by weight of the above polymer (solid content).

Similarly, an epoxy group-containing compound can be used for enhancing the adhesive strength. Examples of the epoxy group-containing compounds include triglycidyl tris(2-hydroxyethyl)isocyanurate, neopentylglycol diglycidyl ether, 1,6-hexanediol diglycidyl ether, allyl glycidyl ether, 2-ethylhexyl glycidyl ether, phenyl glycidyl ether, phenol glycidyl ether, p-tert-butylphenyl glycidyl ether, diglycidyl adipate, diglycidyl o-phthalate, glycidyl methacrylate and butyl glycidyl ether.

Further, the similar effect is also obtained by using an oligomer having an epoxy group and molecular weight of hundreds to thousands, or a polymer having an epoxy group and molecular weight of thousands to hundreds of thousands. The content of the compound having an epoxy group is sufficient in the range of 0.1 to 20 parts by weight based on 100 parts by weight of the reactive polymer (solid content). At least one of the compounds having an epoxy group can be used singly or in combination of two or more kinds.

As other additives, a hydrocarbon resin can be further used for improving processing properties such as laminating properties. The hydrocarbon resin may be either natural resin or synthetic resin. Examples of the natural resins preferably include rosins, rosin derivatives and terpene resins. Examples of the rosins include gum resins, tall oil resins, wood resins. Examples of the rosin derivatives include hydrogenated rosins, disproportionated rosins, polymerized rosins, esterificated rosins, metal salts of rosins. Examples of the terpene resins include α-pinene resins, β-pinene resins, and terpene phenol resins. Moreover, as the natural resin, dammar, copal, shellac can be used. Examples of the synthetic resins preferably include petroleum resins, phenol resins, and xylene resins. Examples of the petroleum resins include aliphatic petroleum resins, aromatic petroleum resins, cycloaliphatic petroleum resins, copolymer type petroleum resins, hydrogenated petroleum resins, pure monomer type petroleum resins, and coumarone-indene resins. Examples of the phenol resins include alkylphenol resins and modified phenol resins. Examples of the xylene resins include xylene resins and modified xylene resins.

The resin such as the hydrocarbon polymer resin can be used in the amount of 1 to 20 parts by weight, preferably 5 to 15 parts by weight based on 100 parts by weight of the polymer (solid content) of the invention

The photo-curable composition may contain, in addition to the above-mentioned additives, an ultraviolet absorber, an aging resistant agent, a dye, and a processing auxiliary agent in a small amount. If desired, particles of silica gel or calcium carbonate may be contained in a small amount.

The photo-curable transfer layer of the invention generally has storage elastic modulus of not more than $1 \times 10^7$Pa which is determined under the conditions of frequency of 1Hz and a temperature of 25°C, especially the storage elastic modulus of $1 \times 10^4$Pa to $6 \times 10^5$Pa. Further, the storage elastic modulus at 80°C is preferably not more than $8 \times 10^4$Pa, especially $1 \times 10^4$Pa to $5 \times 10^5$Pa. Thereby, accurate and speedy transfer is ensured. Further, the photo-curable transfer layer of the invention generally has a glass transition temperature of not more than 20°C. Thereby, in case the resultant photo-curable layer is pressed against a concave-convex surface of a stamper, the photo-curable layer follows accurately the uneven surface even at room temperature to have good flexibility. The photo-curable transfer layer especially has a glass transition temperature of 15 to -50°C, especially 0 to -40°C whereby the resultant photo-curable layer follows more accurately the concave-convex surface. When the glass transition temperature exceeds the upper limit, increased pressure and temperature are needed in the pressing and bonding steps of the sheet, which brings about lowering of workability. When the glass transition temperature falls to below the lower limit, the resultant cured sheet does not have sufficient hardness.

Further, the photo-curable transfer layer comprising the photo-curable composition is preferably configured such that the layer having been subjected to ultraviolet exposure of 300 mJ/cm$^2$ has a glass transition temperature of not less than 65°C. The brief exposure easily prevents sagging of concave shape, which is apt to occur due to residual stress generated in transferring, whereby the transferred shape of concave and the like can be maintained.

The photo-curable transfer sheet of the invention is generally prepared, for example, by homogeneously mixing the ingredients constituting the above-mentioned photo-curable composition, kneading the mixture by using an extruder or roll, and subjecting the kneaded mixture to a film-forming process using a calendar, roll, T-die extrusion or inflation to form a film of a predetermined shape. The photo-curable layer is generally formed on the adhesion layer of the transparent film. A more preferred process for forming the photo-curable sheet comprises the steps of dissolving homogeneously the ingredients in a good solvent, applying the resultant solution onto a separator coated closely with silicone or fluoric resin by means of flow-coater method, roll-coater method, gravure-roll method, mayer-bar method or lip-die coating method, and vaporizing the solvent.

The thickness of the photo-curable transfer sheet generally is in the range of 1 to 1,200 $\mu$m, preferably 5 to 500 $\mu$m, especially 5 to 300 $\mu$m (preferably not more than 150 $\mu$m). When the thickness is thinner than 1$\mu$m, sealing properties are lowered. When the thickness is thicker than 1,200 $\mu$m, the thickness of the resultant molded product is so thick that trouble in housing or assembly of the molded product occurs.

The photo-curable transfer layer preferably has a thickness of 1 to 300 $\mu$m, especially 3 to 100 $\mu$m.

A release sheet can be provided on the photo-curable transfer layer of the photo-curable transfer sheet. The release sheet is generally composed chiefly of a plastic film and a release layer having low surface tension such as silicone provided thereon. The release layer comprises, for example, condensation reaction product of polysiloxane having hydroxy group and hydrogenated polysiloxane, or product formed from polysiloxane (preferably dimethyl polysiloxane) having unsaturated double-bond group (preferably vinyl group) and hydrogenated polysiloxane (preferably dimethyl polysiloxane).

The plastic film of the release sheet is a transparent resin film made mainly of an organic resin. Examples of the organic resin include polyester resin (e.g., polyethylene terephthalate, polycyclohexylene terephthalate, polyethylene naphthalate), polyamide (e.g., nylon 46, modified nylon 6T, nylon MXD6, polyphthalamide), ketone resin (e.g., polyphenylene sulfide, polythioether sulfone), sulfone resin (e.g., polysulfone, polyether sulfone), polyether nitrile, polyarylate, polyether imide, polyamideimide, polycarbonate, polymethyl methacrylate, triacetylcellulose, polystyrene or polyvinyl chloride. Of these resins, polycarbonate, polymethyl methacrylate, polyvinyl chloride, polystyrene and polyethylene terephthalate can be preferably employed, especially polyethylene terephthalate employed. The thickness is generally in the range of 10 to 200 $\mu$m, especially in the range of 30 to 100 $\mu$m.

The photo-curable transfer layer has been preferably subjected to annealing treatment. The annealing treatment is preferably carried out by string the layer at 30 to 100°C especially 40 to 70°C, for 1 hour to 30 days, especially 10 hour to 10 days. The transfer sheet is preferably subjected to annealing treatment in the form of roll (in winding state). The annealing treatment promotes the movement of a component promoting release (demolding component) to the photo-curable transfer layer whereby it is considered that the stamper can be easily removed.

Any photo-curable resin composition for forming a fine concave-convex pattern by using the photo-curable transfer sheet as an intermediate stamper can be used in the invention. A composition usable in a nanoimprint method is preferred. In case the composition is in the form of liquid, the viscosity is preferably in the range of 10 to 10000cps. The photo-curable resin composition comprises preferably a photo-curable resin and a photopolymerization initiator.

Examples of the photo-curable resin include urethane acrylate, polyester acrylate, epoxy acrylate, imide-based oligomer, polyene-thiol-based oligomer.

The urethane acrylate is obtained, for example, by reacting between a diisocyanate such as hexamethylene diisocyanate, isophorone diisocyanate, methylene bis(4-cyclohexyl isocyanate), trimethylhexamethylene diisocyanate, tolylene diisocyanate, 4,4-diphenylmethane diisocyanate, xylylene diisocyanate; and a polyol such as poly(propylene oxide)diol, poly(propylene oxide)triol, poly(tetramethylene oxide)diol, ethoxylated bisphenol; and a hydroxyalkyl (meth)acrylate such as 2-hydroxyethyl acrylate, 2-hydroxyethyl methacrylate, 2-hydroxypropyl acrylate, glycidol dimethacrylate, pentaerythritol acrylate. The urethane acrylate has an acryloyl group and a urethane bond in its molecule.

Examples of the polyester acrylate include polyester acrylate made of phthalic anhydride, propylene oxide and acrylic acid, one made of adipic acid, 1,5-hexane diol and acrylic acid, and one made of trimellitic acid, ethylene glycol and acrylic acid.

The epoxy acrylate is generally synthesized by the reaction an epoxy compound such as epichlorohydrin with acrylic acid or methacrylic acid. The examples include bisphenol-A epoxy acrylate synthesized by the reaction of bisphenol-A epoxy resin, epichlorohydrin and acrylic acid, bisphenol-S epoxy acrylate synthesized by the reaction of bisphenol-S epoxy resin, epichlorohydrin and acrylic acid, bisphenol-F epoxy acrylate synthesized by the reaction of bisphenol-F epoxy resin, epichlorohydrin and acrylic acid, and phenol novolac epoxy acrylate synthesized by the reaction of phenol novolac, epichlorohydrin and acrylic acid.

Examples of the epoxy resin include bisphenol epoxy resins such as bisphenol-A epoxy resin, bisphenol-F epoxy resin, bisphenol-AD epoxy resin, bisphenol-S epoxy resin; novolac epoxy resins such as phenol novolac epoxy resin and cresol novolac epoxy resin; aromatic epoxy resins such as trisphenol methane triglycidyl ether; and hydrogenerated product or bromide thereof.

The photopolymerization initiator is preferably a photo-radical polymerization initiator and a photo-cationic polymerization initiator. Examples of a photo-radical-polymerization initiator include acetophenone derivatives such as 4-(2-hydroxyethoxy)phenyl(2-hydroxy-2-propyl)ketone, $\alpha$-hydroxy-$\alpha$, $\alpha$'-dimethylacetophenone, methoxyacetophenone and 2,2-dimethoxy-2-phenylacetophenone; benzoin ether compounds such as benzoin ethyl ether and benzoin propyl ether; ketal derivatives such as benzyl dimethyl ketal; halogenated ketone, acyl phosphin oxide, acyl phosphonate, 2-ethyl-1-[4-(methylthio)phenyl]-2-morphorinopropane-1-on, 2-benzyl-2-N,N-dimathylamino-1-(4-morphotinophenyl)-1-butanone, bis(2,4,6-trimethylbenzoyl)-phenylphosphinoxidebis-(2,6-dimethoxybenzo yl)-2,4,4-trimethylphentylphosphinoxide, bis($\eta$5-cyclopentadienyl)-bis(pentafluorophenyl)-titanium, bis($\eta$5-cyclopentadienyl)-bis[2,6-difluoro-3-(1H-pyrr-1-yl)phenyl]-titanim, anthracene, perylene, coronene, tetracene, benzanthracene, phenothiazine, flavin, acridine, ketocoumalin, thioxanthone derivatives, benzophenone, acetophenone, 2-chlorothioxanthone, 2,4-dimethylthioxanthone, 2,4-diethylthioxanthone, 2,4-dipropylthioxanthone, and isopropylthioxanthone. Examples of a photo-cationic-polymerization initiator include iron-allene complexes, aromatic diazonium salts, aromatic iodonium salts, aromatic sulfonium salts, onium salts, pyridinium salts, aluminum complexes/silanol salts, trichloromethyl triazine derivatives. Examples of counter anions of the onium salts or pyridinium salts include $SbF_6^-$, $PF_6^-$, $AsF_6^-$, $BF_4^-$, tetrakis(pentafluoro)borate, trifluoromethane sulfonate, methane sulfonate, trifluoro acetate, acetate, sulfonate, tosylate, nitrate.

The additive amount of the photopolymerization initiator generally is in the range of 0.1 to 15 part by weight, preferably 0.5 to 10 part by weight, based on 100 parts of the photo-curable resin.

The photo-curable resin composition may contain a reactive diluent. Examples of the reactive diluent include 1,4-butane diol diacrylate, 1,6-hexane diol diacrylate, neopentyl glycol diacrylate, 2-(2-ethoxyethoxy)ethyl acrylate, tetrahydorofurfuryl acrylate, 2-phenoxyethyl acrylate, diethylene glycol diacrylate, tetraethylene glycol diacrylate, 1,3-butylene glycol diacrylate, tripropylene glycol diacrylate, trimethylolpropane triacrylate, pentaerythritol tetraacrylate, hydoxypivalic acid neopentyl glycol diacrylate.

The photo-curable resin composition of the invention may contain further, if desired, known photopolymerization initiators, thermal polymerization inhibitors, fillers, tackifiers, thixotropy imparting agents, plasticizers, colorants.

In case the photo-curable transfer sheet and the photo-curable resin layer of the invention is cured, it is possible to adopt, as light source used, various sources generating light in the wavelength range of from ultraviolet to visible rays. Examples of the sources include a super-high-pressure lamp, a high-pressure lamp, a low-pressure mercury lamp, a chemical lamp, a xenon lamp, a halogen lamp, a mercury halogen lamp, a carbon arc lamp, and an incandescent electric lamp, and laser beam. The exposing time is generally in the range of 0.1 second to dozens seconds, preferably 0.5 second to a few seconds, depending upon kinds of the lamp and strength of light. The amount of the ultraviolet exposure preferably is not less than 300 mJ/cm$^2$.

To promote the curing, the laminate may be heated beforehand for 30 to 80°C, and then the heated laminate may be exposed to ultraviolet rays.

The invention is illustrated in detail using the following Examples.

EXAMPLE

[Examples 1 to 3, Comparison Examples 1 to 5]

<Preparation of photo-curable transfer sheet>

By using a silicone resin (X-22-1602: polydimethylsiloxane having methacryloyloxy group through a polyether chain; available from Shin-Etsu Chemical Co., Ltd.), BYK-UV3500 (polydimethylsiloxane having acryloyloxy group through a polyether chain; available from BYK Japan KK) and a fluorine-atom-containing ethylenic compound (V-3F, 2,2,2-trifluoroethyl acrylate; available from Osaka Organic Chemical Industry Co., Ltd.), a surface energy of a photochemical transfer layer was adjusted to prepare a photo-chemical transfer sheet.

In more detail, each formulation (composition) of Examples 1-3 and Comparison Examples 1-5 was homogeneously dissolved and mixed to give a mixture, which was applied onto a whole surface of a transparent film (Trade name: HPE, width: 300mm, length: 300m, thickness: 75 $\mu$m; available from Teijin DuPont Films Japan Limited) and dried to form a photo-curable transfer layer of thickness of 25 $\mu$m. Subsequently, a release sheet (Trade name: A31, width: 300mm, length: 300m, thickness: 50 $\mu$m; available from Teijin DuPont Films Japan Limited) was attached to the opposite side of the photo-curable transfer layer to be rolled up in the form of roll. Thus, a full-edge type roll of photo-curable transfer sheet of diameter of 260mm was prepared. The transparent film is composed of a PET film (75 $\mu$m) and an adhesion layer (a mixture of polyester and acrylic resin, thickness: 0.2 $\mu$m) thereon. A surface energy of each of the photo-chemical transfer sheet is shown in Table 2.

[Table 2]

| (Composition of photo-curable transfer layer) | | | | | | | | | |
|---|---|---|---|---|---|---|---|---|---|
| | Trade name | Co. Ex. 1 | Ex.1 | Co. Ex. 2 | Co. Ex. 3 | Co. Ex. 4 | Ex. 2 | Co. Ex. 5 | Ex. 3 |
| | | Parts by weight | | | | | | | |
| Base Polymer | BORESA-7 | 100 | ← | ← | ← | ← | ← | ← | ← |
| Monomer | SR238F | 100 | ← | ← | ← | ← | ← | ← | ← |
| | TMF-A | 10 | ← | ← | ← | ← | ← | ← | ← |
| | G-201P | 10 | ← | ← | ← | ← | ← | ← | ← |
| Photo initiator | Irgercure 651 | 2.0 | ← | ← | ← | ← | ← | ← | ← |
| Hardener | BXX5627 | 1.5 | ← | ← | ← | ← | ← | ← | ← |
| Inhibitor | MEHQ | 0.05 | ← | ← | ← | ← | ← | ← | ← |
| Lubricant | X22-1602 | - | 0.1 | 0.37 | 1.37 | - | - | - | - |
| | UV3500 | - | - | - | - | 0.1 | 0.37 | 1.37 | - |
| | V-3P | - | - | - | - | - | - | - | 10 |
| *Surface Energy | mN/m | 43 | 25 | 18 | 16 | 35 | 27 | 20 | 25 |

Note)
BORESA-7 (Osaka Organic Chemical Industry Co., Ltd.); SR238F (Hexanediol diacrylate; Sartomer);
TMF-A (Trimethylol propane triacrylate; KYOEISHA CHEMICAL Co.,LTD);
G-201P (2-Hydroxy-3-acryloyloxypropyl methacrylate; KYOEISHA CHEMICAL Co., LTD); Irgercure 651 (Chiba-Speciality-Chemicals);
BXX5627 (Diisocyanate; Toyo Ink. Mfg.); MEHQ (Hydroquinone monomethyl ether; Kawaguchi Chemical Industry Co., LTD.)
*surface Energy is determined by measuring a contact angle (a contact angle instrument (Drop-master, available from Kyowa Interface Science Co., Ltd.,), standard solvent: water, 1-bromonaphthalene, diiodomethane) and subjecting the obtained value to the analytical method of Kitazaki and Hata.

A process for forming a concave-convex pattern shown in Fig. 4 was performed by using the photo-curable transfer sheets of Examples 1-3 and Comparison Examples 1-5. In more detail, a fine concave-convex pattern was formed on a photo-curable resin layer composed of a liquid photo-curable resin composition (Resin for UV-nanoimprint: PAK-1, available from Toyo Gosei Co., Ltd.) formed on a silicon substrate by using a stamper made of nickel having a fine concave-convex pattern (Shape of pattern: depth of 50nm, height of 50nm, shape of rib) and each of the photo-curable transfer sheets as an intermediate stamper. The forming (molding) was carried out under the conditions of a takt time (stop time period for UV exposure) of 2 sec., a temperature of 50°C and UV light amount of 300m J/cm$^2$.

In the process, transfer property of each of the photo-curable transfer sheets, the adhesion to substrate (transparent film) and the peeling property are evaluated. The transfer property is evaluated by comparison of difference between the shape of concave-convex pattern of the stamper and that of the photo-curable transfer sheet or that of the photo-curable resin layer by using a transmission electron microscope (O: The difference between the shapes is not observed. $\times$ : The difference between the shapes is observed). The adhesion to substrate and the peeling property are evaluated by visual observation (O : Good; $\times$ : No-good). The obtained results are shown in Table 3.

[Table 3]

| (Evaluation of process for forming concave-convex pattern) | | | | | | | | | | | | | |
|---|---|---|---|---|---|---|---|---|---|---|---|---|---|
| | Lubricant | Surface Energy (mN/m) | Transfer of stamper to photo-curable transfer sheet (intermediate stamper) | | | | | Transfer of intermediate stamper to photo-curable resin layer | | | | | |
| | | | Transfer property | Adhesion to substrate | Peeling property | Conditions of forming | | Transfer property | Adhesion to substrate | Peeling property | Conditions of forming | | |
| | | | | | | Takt time | UV amount $(mJ/cm^2)$ | | | | Takt time | UV amount $(mJ/cm^2)$ |
| Co. Ex. 1 | - | 43 | O | O | × | 2 sec. | 300 | No-good in all the steps | | | - | - |
| Ex. 1 | X22-1602 | 25 | O | O | O | 2 sec. | 300 | O | O | O | 2 sec. | 300 |
| Co. Ex. 2 | ↑ | 18 | O | O | O | 2 sec. | 300 | × | O | O | 2 sec. | 300 |
| Co. Ex. 3 | ↑ | 16 | O | × | O | 2 sec. | 300 | No-good in all the steps | | | - | - |
| Co. Ex. 4 | UV-3500 | 35 | O | O | O | 2 sec. | 300 | O | O | × | 2 sec. | 300 |
| Ex. 2 | ↑ | 27 | O | O | O | 2 sec. | 300 | O | O | O | 2 sec. | 300 |
| Co. Ex. 5 | ↑ | 20 | O | × | O | 2 sec. | 300 | No-good in all the steps | | | - | - |
| Ex. 3 | V-3F | 25 | O | O | O | 2 sec. | 300 | O | O | O | 2 sec. | 300 |

As indicated in Table 3, Comparison Examples 2, 3 and 5 using the photo-curable transfer layers having surface energy of not more than 20mN/m showed adhesion to the substrate of "no-good" and transfer property to the liquid photo-curable resin layer of "no-good". Further, Comparison Examples 1 and 4 using the photo-curable transfer layers having surface energy of not less than 30mN/m showed peeling property from the nickel stamper of "no-good" or peeling property from the liquid photo-curable resin layer of "no-good".

In contrast, Examples 1 to 3 using the photo-curable transfer layers having surface energy of more than 20mN/m and less than 30mN/m showed good transfer property, good adhesion to the substrate and good peeling property, and therefore a good concave-convex pattern can be efficiently formed.

The present invention is not restricted to the above-mentioned embodiments and Examples, and can be modified variously within the gist of the invention.

Explanation of reference numbers

**[0154]**

| | |
|---|---|
| 10, 30: | Photo-curable transfer sheet |
| 11, 31: | Photo-curable transfer layer |
| 11c, 31c: | Photo-curable transfer layer (after curing) |
| 12, 3 2: | Transparent film |
| 12a: | Adhesion layer |
| 12b: | Polymer film |
| 13, 33: | Release sheet |
| 14: | Stamper |
| 15, 40: | Substrate |
| 16, 41: | Photo-curable resin layer |
| 20: | Intermediate stamper |
| 34: | Stamper part |
| 35, 45: | UV- transmission type pressure bonding part |
| 36a: | Lead-on roll |
| 36b, 36f: | Wind-up roll |
| 36c, 36d, 36e: | Guide roll 36c |
| 37, 47: | UV lamp |

**Claims**

1. A photo-curable transfer sheet having a photo-curable transfer layer comprising a photo-curable composition deformable by application of pressure,
   wherein the photo-curable composition comprises as a lubricant a silicone resin and/or a fluorine-atom-containing ethylenic compound, and a surface energy of the photo-curable transfer layer is more than 20mN/m and less than 30mN/m.

2. A photo-curable transfer sheet as defined in claim 1, wherein the silicone resin is a modified polysiloxane.

3. A photo-curable transfer sheet as defined in claim 2, wherein the modified polysiloxane is a polysiloxane containing a (meth)acryloyl group.

4. A photo-curable transfer sheet as defined in claim 1, wherein the fluorine-atom-containing ethylenic compound is one of fluoro (meth)acrylates.

5. A photo-curable transfer sheet as defined in any of claims 1 to 4, wherein a transparent film comprising an adhesion layer and a polymer film is provided on one surface of the photo-curable transfer layer, and the adhesion layer is in contact with the photo-curable transfer layer.

6. A photo-curable transfer sheet as defined in claim 5, wherein the polymer film is a polyester film.

7. A photo-curable transfer sheet as defined in claim 5 or 6, wherein the adhesion layer comprises at least one selected from a polyester resin, a polyurethane resin and an acrylic resin.

**8.** A method for forming a concave-convex pattern comprising of the steps (1) to (3):

a step (1) of placing a mold having a fine concave-convex pattern surface thereon on the photo-curable transfer layer of the photo-curable transfer sheet as defined in any of claims 1 to 7, such that the concave-convex pattern surface of the mold is in contact with a surface of the photo-curable transfer layer, and depressing the mold and the photo-curable transfer sheet to form a laminate in which one surface of the photo-curable transfer layer adheres closely to the concave-convex pattern surface;
a step (2) of exposing the photo-curable transfer layer of the laminate having the mold to ultraviolet rays to cure the photo-curable transfer layer, and
a step (3) of removing the mold from the laminate to form an inverted pattern of the fine concave-convex pattern on a surface of the photo-curable transfer layer.

**9.** A method for forming a concave-convex pattern comprising of the steps (4) to (6):

a step (4) of placing the photo-curable transfer sheet having the inverted pattern of the fine concave-convex pattern obtained by the method as defined in claim 8, which is referred to as an intermediate stamper, on a photo-curable resin layer consisting of a photo-curable resin composition formed on a substrate, such that the inverted concave-convex pattern surface of the intermediate stamper is in contact with a surface of the photo-curable resin layer and depressing the intermediate stamper and the photo-curable resin layer having the substrate to form a laminate in which the surface of the photo-curable resin layer adheres closely to the inverted concave-convex pattern surface; and
a step (5) of exposing the photo-curable resin layer of the laminate having the intermediate stamper to ultraviolet rays to cure the photo-curable resin layer, and
a step (6) of removing the intermediate stamper from the laminate to form a fine concave-convex pattern on a surface of the photo-curable resin layer, the fine concave-convex pattern being the same as that of the mold.

**10.** A method for forming a concave-convex pattern as defined in claim 9, wherein the photo-curable resin composition is in the form of liquid.

**11.** A method for forming a concave-convex pattern as defined in any of claims 8 to 10, wherein the mold is a stamper.

FIG. 1

# FIG. 2

(a)

(b)

Exposure to UV

(c)

# FIG. 3

(d)

20

12b ⎫ 12
12a ⎭
11c

16

15

(e)

20

12b ⎫ 12
12a ⎭
11c

16

15

Exposure to UV

(f)

20

12b ⎫ 12
12a ⎭
11c

16

15

FIG. 4

<table>
<tr><td align="center">**INTERNATIONAL SEARCH REPORT**</td><td>International application No.<br>PCT/JP2010/050134</td></tr>
</table>

A. CLASSIFICATION OF SUBJECT MATTER
*H01L21/027*(2006.01)i, *B29C59/02*(2006.01)i, *G11B7/26*(2006.01)i, *B29K33/04* (2006.01)n, *B29K83/00*(2006.01)n, *B29L7/00*(2006.01)n

According to International Patent Classification (IPC) or to both national classification and IPC

B. FIELDS SEARCHED

Minimum documentation searched (classification system followed by classification symbols)
H01L21/027, 21/30B29C59/02, G11B7/26, B29K33/04, B29K83/00, B29L7/00

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2010 |
| Kokai Jitsuyo Shinan Koho | 1971–2010 | Toroku Jitsuyo Shinan Koho | 1994–2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2005-515617 A (Brewer Science, Inc.),<br>26 May 2005 (26.05.2005),<br>paragraphs [0013], [0022] to [0046]; fig. 1, 2<br>& US 2003/0071016 A1    & US 2005/0167894 A1<br>& EP 1441868 A          & WO 2003/031096 A2<br>& CA 2462347 A          & TW 578200 B<br>& KR 10-2005-0035134 A | 1-4<br>5-11 |
| Y<br>A | JP 10-307201 A (Toppan Printing Co., Ltd.),<br>17 November 1998 (17.11.1998),<br>paragraphs [0026] to [0029]<br>(Family: none) | 5-11<br>1-4 |

☒ Further documents are listed in the continuation of Box C.    ☐ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>27 January, 2010 (27.01.10) | Date of mailing of the international search report<br>09 February, 2010 (09.02.10) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2010/050134

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2007-055235 A (Obducat, AB.),<br>08 March 2007 (08.03.2007),<br>paragraphs [0018] to [0021]<br>& JP 2008-542081 A       & US 2006/0279025 A1<br>& US 2007/0212522 A1     & EP 1731961 A1<br>& EP 1731962 A1          & EP 1731965 A2<br>& EP 1959299 A2          & WO 2006/131153 A1<br>& DE 602005010839 D      & DE 602005012068 D<br>& KR 10-2006-0128749 A   & CN 1916759 A<br>& KR 10-2008-0023252 A   & AT 4136 | 1-11 |
| A | JP 2006-054300 A (Asahi Glass Co., Ltd.),<br>23 February 2006 (23.02.2006),<br>paragraph [0008]<br>(Family: none) | 1-11 |
| A | JP 2007-165812 A (Obducat, AB.),<br>28 June 2007 (28.06.2007),<br>paragraphs [0011], [0033], [0034]<br>& US 2007/0134362 A1      & EP 1795497 A1<br>& KR 10-2007-0061061 A   & CN 1979336 A<br>& SG 133485 A | 1-11 |
| A | JP 2006-156735 A (Nippon Telegraph And<br>Telephone Corp.),<br>15 June 2006 (15.06.2006),<br>paragraphs [0019] to [0042]; fig. 1<br>(Family: none) | 1-11 |
| A | US 2005/0191419 A1 (James M. Helt),<br>01 September 2005 (01.09.2005),<br>entire text; all drawings<br>& WO 2004/092836 A1 | 1-11 |
| A | JP 2008-202022 A (Fujifilm Corp.),<br>04 September 2008 (04.09.2008),<br>paragraph [0165]<br>& KR 10-2008-0069553 A | 1-11 |
| A | JP 2005-286222 A (Toshiba Corp.),<br>13 October 2005 (13.10.2005),<br>paragraphs [0018], [0019]<br>(Family: none) | 1-11 |
| A | JP 09-063130 A (Dainippon Printing Co., Ltd.),<br>07 March 1997 (07.03.1997),<br>entire text; all drawings<br>(Family: none) | 1-11 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007165812 A

- JP 9063130 A

**Non-patent literature cited in the description**

- **Yasuaki Kitazaki ; Toshio Hata.** *Journal of The Adhesion of Japan,* 1972, vol. 8 (3), 131-141